# EUROPEAN PATENT APPLICATION

(11) **EP 4 607 281 A2**
(43) Date of publication of application: **27.08.2025**
(21) Application number: 25157148.5
(22) Date of filing: 11.02.2025
(51) Int. Cl.: G03F 7/09

(54) **METHOD FOR FORMING ORGANIC FILM AND METHOD FOR MANUFACTURING SUBSTRATE FOR SEMICONDUCTOR DEVICE**

(30) Priority: 20.02.2024 JP 2024024089
(71) Applicant: SHIN-ETSU CHEMICAL CO., LTD., Tokyo 1000005 (JP)
(72) Inventor: KOBAYASHI, Naoki, Niigata (JP); TAKIZAWA, Kanata, Niigata (JP); YANO, Toshiharu, Niigata (JP); SATOH, Hironori, Niigata (JP)
(74) Representative: Sonnenhauser, Thomas Martin

(57) **Abstract**

The present invention provides a method for forming an organic film on a substrate having a concave-convex pattern, the method including the steps of: forming a coating film on the substrate by spin-coating with a composition for forming an organic film; spin-coating the coating film with a coating solvent that is capable of dissolving the coating film and has a normal boiling point of 160°C or higher and lower than 500°C; and forming an organic film by subjecting the coating film to an insolubilization treatment against the coating solvent. This can provide a method for forming an organic film that makes it possible to fill a concave-convex pattern in a substrate and highly planarize the substrate at low cost in a process of manufacturing a semiconductor device or the like.

## Description

### TECHNICAL FIELD

The present invention relates to: a method for forming a flat organic film usable in a process of finely processing a semiconductor device or the like; and a method for manufacturing a substrate for a semiconductor device, the method using the method for forming an organic film.

### BACKGROUND ART

Advancement toward higher processing performance of semiconductor devices has been led by the miniaturization of pattern dimensions achieved by light sources having shorter wavelengths in lithography technology. However, the speed of the shortening of light-source wavelengths has slowed down after ArF, and advancement in performance to take the place of miniaturization is required. Accordingly, development is in progress regarding techniques that make it possible to achieve higher performance in semiconductor devices by providing semiconductor devices with three-dimensional structures and arranging transistors with higher density. In a substrate of such a semiconductor device having a three-dimensional structure, a structure that is deeper and thinner than structures in previous substrates is formed as a circuit pattern. Therefore, lithography techniques optimized for forming conventional flat structures cannot achieve a practical process margin. Accordingly, it is necessary to ensure a process margin by applying a material capable of planarizing a substrate in which a three-dimensional structure has been formed to form a flat surface, and then patterning the flat surface by a lithography technique.

As techniques that allow the formation of such a flat surface, many techniques for forming a flat film made from a spin-coating type organic film are already known (Patent Documents 1-5), but organic films formed with such materials cannot deal with all patterns of substrates for manufacturing semiconductor devices. Furthermore, there are also suggestions to add a liquid additive of polyether polyol, polyacetal, etc. (Patent Documents 6-7), but such additives generally have poor dry etching resistance. Therefore, if the additive remains in a coating film, dry etching resistance at the time of substrate processing may be insufficient, and dry etching resistance may be insufficient for an organic film for substrate processing. In addition, as a planarizing method, a method has been put to practical use, according to which the unevenness on a substrate is filled, and then the substrate is planarized by a chemical mechanical polishing (CMP) process (Patent Document 8). However, CMP is a high-cost process. In this situation, there are demands for a method for highly planarizing a substrate for manufacturing a semiconductor device by using an organic film at low cost.

### CITATION LIST

### PATENT LITERATURE

Patent Document 1: JP 2005-292528 A
Patent Document 2: JP 2008-65081 A
Patent Document 3: JP 2008-242492 A
Patent Document 4: JP 2014-24831 A
Patent Document 5: JP 2014-219559 A
Patent Document 6: WO 2008/026468 A1
Patent Document 7: JP 2013-253227 A
Patent Document 8: JP 2004-335873 A

### SUMMARY OF INVENTION

### TECHNICAL PROBLEM

The present invention has been made in view of the above-described circumstances. An object of the present invention is to provide a method for forming an organic film that makes it possible to fill a concave-convex pattern in a substrate and highly planarize the substrate at low cost in a process of manufacturing a semiconductor device or the like.

### SOLUTION TO PROBLEM

To achieve the object, the present invention provides a method for forming an organic film on a substrate having a concave-convex pattern, the method comprising the steps of:
forming a coating film on the substrate by spin-coating with a composition for forming an organic film;
spin-coating the coating film with a coating solvent that is capable of dissolving the coating film and has a normal boiling point of 160°C or higher and lower than 500°C; and
forming an organic film by subjecting the coating film to an insolubilization treatment against the coating solvent.

According to such a method, it is possible to form an organic film that can fill a concave-convex pattern in a substrate and highly planarize the substrate at low cost in a process of manufacturing a semiconductor device or the like.

It is preferable that any of a heat treatment at 100°C or higher and 600°C or lower, an irradiation treatment with an ultraviolet ray having a wavelength of 400 nm or less, an irradiation treatment with an electron beam, and an irradiation treatment with plasma, or a combination thereof is used as the insolubilization treatment.

By performing the insolubilization treatment according to such means, it is possible to form an organic film that maintains a flat state.

It is preferable that an alcohol, an ester, a ketone, a carbonate, an ether, or a combination thereof is used as the coating solvent.

By using such a coating solvent, it is possible to form an organic film that highly planarizes a substrate.

An aromatic group-containing compound having a benzyl group or a benzoyl group is preferably used as the coating solvent.

When such an aromatic group-containing compound is used, suitable solubility, wettability, etc. to the organic film can be achieved, and the organic film can be planarized more highly.

A composition containing a resin containing one or more aromatic rings is preferably used as the composition for forming an organic film.

In the inventive method for forming an organic film, a composition for forming an organic film containing a resin containing an aromatic ring can be used suitably from the viewpoints of etching resistance, optical characteristics, and heat resistance.

The present invention also provides a method for manufacturing a substrate for a semiconductor device, the method comprising:
forming an organic film on a substrate having a concave-convex pattern by the above-described method;
forming a silicon-containing resist middle layer film on the organic film by using a silicon-containing composition for forming a resist middle layer film;
forming a resist upper layer film on the silicon-containing resist middle layer film by using a photoresist composition;
forming a circuit pattern in the resist upper layer film;
transferring the pattern to the silicon-containing resist middle layer film by dry etching while using the resist upper layer film having the formed pattern as a mask;
transferring the pattern to the organic film by dry etching while using the silicon-containing resist middle layer film having the transferred pattern as a mask; and
further transferring the pattern to the substrate by dry etching while using the organic film having the transferred pattern as a mask.

The present invention also provides a method for manufacturing a substrate for a semiconductor device, the method comprising:
forming an organic film on a substrate having a concave-convex pattern by the above-described method;
forming a silicon-containing resist middle layer film on the organic film by using a silicon-containing composition for forming a resist middle layer film;
forming an organic antireflective film on the silicon-containing resist middle layer film;
forming a resist upper layer film on the organic antireflective film by using a photoresist composition to obtain a four-layer resist film;
forming a circuit pattern in the resist upper layer film;
transferring the pattern to the organic antireflective film and the silicon-containing resist middle layer film by dry etching while using the resist upper layer film having the formed pattern as a mask;
transferring the pattern to the organic film by dry etching while using the organic antireflective film and the silicon-containing resist middle layer film having the transferred pattern as a mask; and
further transferring the pattern to the substrate by dry etching while using the organic film having the transferred pattern as a mask.

The present invention also provides a method for manufacturing a substrate for a semiconductor device, the method comprising:
forming an organic film on a substrate having a concave-convex pattern by the above-described method;
forming an inorganic hard mask selected from the group consisting of a silicon oxide film, a silicon nitride film, a silicon oxynitride film, an amorphous silicon film, and a titanium nitride film on the organic film;
forming a resist upper layer film on the inorganic hard mask by using a photoresist composition;
forming a circuit pattern in the resist upper layer film;
transferring the pattern to the inorganic hard mask by dry etching while using the resist upper layer film having the formed pattern as a mask;
transferring the pattern to the organic film by dry etching while using the inorganic hard mask having the transferred pattern as a mask; and
further transferring the pattern to the substrate by dry etching while using the organic film having the transferred pattern as a mask.

The present invention also provides a method for manufacturing a substrate for a semiconductor device, the method comprising:
forming an organic film on a substrate having a concave-convex pattern by the above-described method;
forming an inorganic hard mask selected from the group consisting of a silicon oxide film, a silicon nitride film, a silicon oxynitride film, an amorphous silicon film, and a titanium nitride film on the organic film;
forming an organic antireflective film or a multilayer resist film comprising an organic film and a silicon-containing resist middle layer film on the inorganic hard mask;
forming a resist upper layer film on the organic antireflective film or the multilayer resist film by using a photoresist composition;
forming a circuit pattern in the resist upper layer film;
transferring the pattern to the inorganic hard mask by dry etching via pattern transfer to the organic antireflective film or the multilayer resist film while using the resist upper layer film having the formed pattern as a mask;
transferring the pattern to the organic film formed on the substrate by dry etching while using the inorganic hard mask having the transferred pattern as a mask; and
further transferring the pattern to the substrate by dry etching while using the organic film having the transferred pattern as a mask.

As described above, an organic film formed by the inventive method has excellent planarizing property. Therefore, when the organic film is used in combination with various film materials in multilayer resist processes, for example, two-layer resist processes, three-layer resist processes using a silicon-containing resist middle layer film, or four-layer resist processes using a silicon-containing resist middle layer film and an organic antireflective film, it is possible to transfer an upper layer photoresist (resist upper layer film) pattern to the substrate with high precision and form the pattern in the substrate. That is, according to the inventive method for manufacturing a substrate for a semiconductor device, it is possible to manufacture a substrate for a semiconductor device highly accurately.

In this case, the inorganic hard mask is preferably formed by a chemical vapor deposition (CVD) method or an atomic layer deposition (ALD) method.

In the inventive method for manufacturing a substrate for a semiconductor device, the inorganic hard mask can be formed by such a method, for example.

The circuit pattern is preferably formed by any of a lithography with a high-energy beam having a wavelength of 10 nm or more and 300 nm or less, a direct writing with electron beam, and nanoimprinting, or a combination thereof.

Furthermore, the circuit pattern is preferably developed by alkaline development or development with an organic solvent.

In the inventive method for manufacturing a substrate for a semiconductor device, such means of forming and developing the circuit pattern can be used suitably.

### ADVANTAGEOUS EFFECTS OF INVENTION

As described above, according to the present invention, it is possible to form an organic film that can fill a concave-convex pattern in a substrate and can highly planarize the substrate. In addition, the substrate can be highly planarized without using CMP, which is a high-cost process, and therefore, the substrate can be planarized at low cost. Furthermore, an organic film formed by the inventive method has excellent planarizing property, and therefore, is extremely useful for manufacturing a semiconductor device. By using this organic film in combination with various film materials in multilayer resist processes, such as a two-layer resist process, a three-layer resist process using a silicon-containing resist middle layer film, or a four-layer resist process using a silicon-containing resist middle layer film and an organic antireflective film, it is possible to transfer an upper layer photoresist (resist upper layer film) pattern to the substrate with high precision and form the pattern in the substrate. That is, according to the inventive method for manufacturing a substrate for a semiconductor device, high-precision manufacturing of a substrate for a semiconductor device is possible.

### BRIEF DESCRIPTION OF DRAWINGS

FIG. 1 is a flow diagram of an example in which an organic film is formed on a substrate having a trench pattern according to the inventive method for forming an organic film.
FIG. 2 is a flow diagram of an example in which an organic film is formed on a substrate having a line pattern according to the inventive method for forming an organic film.
FIG. 3 is an explanatory diagram of a method for evaluating the trench-pattern (pattern A) planarizing property of the present invention.
FIG. 4 is an explanatory diagram of a method for evaluating the line-pattern (pattern B) planarizing property of the present invention.

### DESCRIPTION OF EMBODIMENTS

As described above, there has been required the development of a method for forming an organic film that makes it possible to fill a concave-convex pattern in a substrate and highly planarize the substrate at low cost in a process of manufacturing a semiconductor device or the like.

Conventionally, as a method for planarizing a substrate having a concave-convex pattern, for example, a substrate in which part or all of a semiconductor circuit has been formed, a concave-convex pattern on a surface of a substrate has been filled with an organic film to form a flat surface by spin-coating the substrate with a composition for forming an organic film and then baking the composition. However, although, according to this method, it is possible to fill fine concave-convex portions on the surface, it is difficult to form a flat surface uniformly in portions where the density of the pattern that needs to be filled is high and portions where the density of the pattern is low when regarding the entire surface of the substrate. Generally, a composition that has been applied forms a coating film having a concave-convex shape that follows the concave-convex pattern formed in the substrate.

Usually, in a process of forming a semiconductor circuit, such a coating film is subjected to an insolubilization treatment, and then the process proceeds to a step of forming the next film. The present inventors have earnestly studied the planarization of a substrate, and found out that an extremely flat organic film can be formed by applying a composition for forming an organic film, and then, before the insolubilization treatment, spin-coating the coating film with a coating solvent having a normal boiling point of 160°C or higher and lower than 500°C to allow the coating film to flow. Thus, the present invention has been completed. Note that, in the present invention, "normal boiling point" means the boiling point at 1 atmosphere (1013.25 hPa). Hereinafter, this may be referred to simply as "boiling point".

That is, the present invention is a method for forming an organic film on a substrate having a concave-convex pattern, the method comprising the steps of:
forming a coating film on the substrate by spin-coating with a composition for forming an organic film;
spin-coating the coating film with a coating solvent that is capable of dissolving the coating film and has a normal boiling point of 160°C or higher and lower than 500°C; and
forming an organic film by subjecting the coating film to an insolubilization treatment against the coating solvent.

Hereinafter, the present invention will be described in detail, but the present invention is not limited thereto.

The present invention relates to: a method for forming a very flat organic film usable in a process of finely processing a semiconductor device or the like; and a method for manufacturing a substrate for a semiconductor device, the method using the method for forming an organic film.

In the following, the inventive method for forming an organic film and method for manufacturing a substrate for a semiconductor device, using the method for forming an organic film, will be described.

### <Method for Forming Organic Film>

The present invention relates to a method for forming an organic film on a substrate having a concave-convex pattern, and includes the steps of:
forming a coating film on the substrate by spin-coating with a composition for forming an organic film (step of forming coating film);
spin-coating the coating film with a coating solvent that is capable of dissolving the coating film and has a normal boiling point of 160°C or higher and lower than 500°C (step of applying coating solvent); and
forming an organic film by subjecting the coating film to an insolubilization treatment against the coating solvent (step of forming organic film).

In the present invention, a coating solvent is an organic solvent to be applied to the coating film formed on the substrate, and is an organic solvent that is capable of dissolving the coating film and has a normal boiling point of 160°C or higher and lower than 500°C. The coating solvent may be different from or the same as an organic solvent contained in the coating film (derived from an organic solvent contained in the composition for forming an organic film), but preferably has a normal boiling point higher than the normal boiling point of the organic solvent contained in the coating film.

As the normal boiling point, a value disclosed in Handbook of Chemistry: Pure Chemistry (6th ed., The Chemical Society of Japan ed., Maruzen Publishing Co., Ltd., Jan. 2021), Yozai Handbook (Teruzo Asahara et al. ed., Kodansha Ltd., 1976), etc. can be adopted, and may also be determined from the boiling point under a reduced pressure of lower than 1 atmosphere according to the method described in the document, Science of Petroleum (Vol. II, p. 1281, (1938)).

Incidentally, spin-coating methods include: static dispense, where a solution (fluid) is dropped on a substrate in a static state, and after dropping the solution, the substrate is rotated to coat with the solution; and dynamic dispense, where a solution is dropped while the substrate is rotated to coat with the solution. In the present invention, either static dispense or dynamic dispense can be adopted.

In the following, the present invention will be described with reference to drawings.

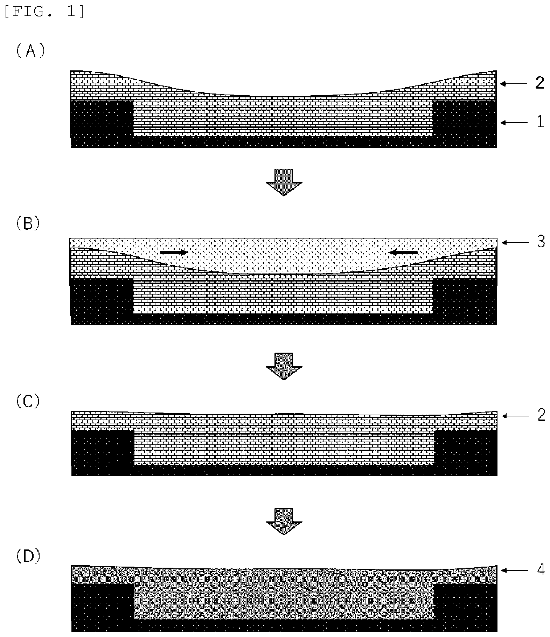

FIG. 1 is a flow diagram of an example in which an organic film is formed on a substrate having a trench pattern according to the inventive method for forming an organic film. In the method of FIG. 1, firstly, a substrate 1 is spin-coated with a composition for forming an organic film to form a coating film 2. In this event, due to the effect of the concave-convex pattern in the substrate 1, the coating film 2 having a concave-convex shape that follows the shape of the substrate is formed (FIG. 1 (A)). A treatment is performed to spin-coat the coating film 2 with a coating solvent 3 having a normal boiling point of 160°C or higher and lower than 500°C. When the coating solvent 3 is applied to the uncured coating film 2, the coating film 2 (mainly the resin in the coating film 2) flows (FIG. 1 (B)). As a result, the concave-convex shape is resolved, and a flat coating film 2 is formed (FIG. 1 (C)). Lastly, the flat coating film 2 can be insolubilized by treatment with heat, light, plasma, or any combination thereof to form a flat organic film 4 (FIG. 1 (D)). On the insolubilized organic film 4, a composition for forming a coating film, such as a composition for forming a silicon-containing resist middle layer film described later, can be applied by spin-coating to form a coating film. Incidentally, in the method of FIG. 1, after forming the coating film 2, the organic solvent contained in the coating film 2 may be removed by treatment with heat, light, plasma, or any combination thereof to such an extent that the coating film 2 does not cure completely.

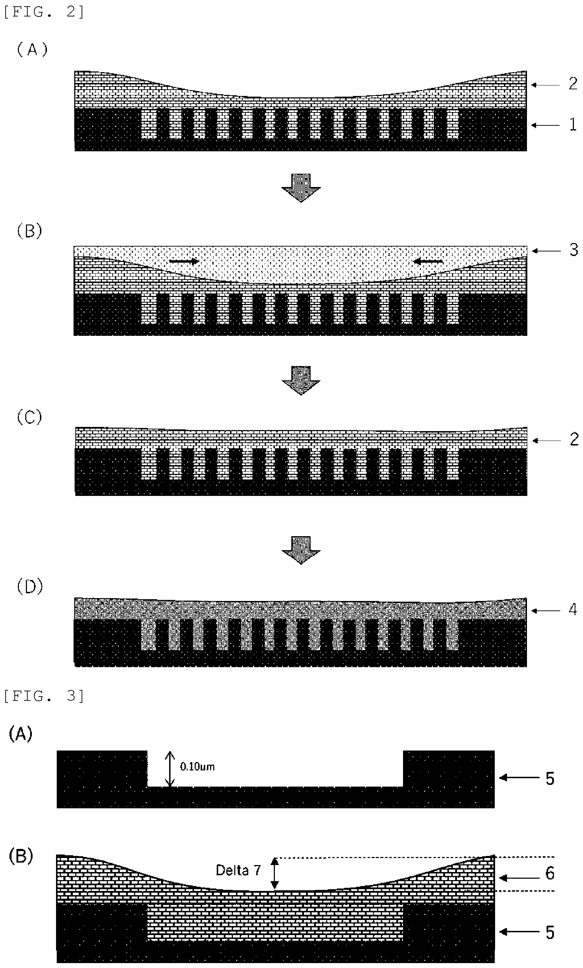

FIG. 2 is a flow diagram of an example in which an organic film is formed on a substrate having a line pattern (line-and-space pattern) in a wide range in a portion having a fine pattern according to the inventive method for forming an organic film. In the method of FIG. 2, firstly, a substrate 1 is spin-coated with a composition for forming an organic film to form a coating film 2. In this event, if the pattern has a wide pitch, the coating film 2 having a concave-convex shape that follows the shape of the substrate is formed due to the effect of the concave-convex pattern in the substrate as shown in FIG. 1, but in the case of a fine pattern, for example, a pattern having a half-pitch finer than 200 nm, the film does not follow individual patterns, and the coating film 2 having a concave shape in the central portion of the pattern on average (having a gentle concave shape over the entire patterned portion) is formed (FIG. 2 (A)). A treatment is performed to spin-coat the coating film 2 with a coating solvent 3 having a normal boiling point of 160°C or higher and lower than 500°C. When the coating solvent 3 is applied to the uncured coating film 2, the coating film 2 (mainly the resin in the coating film 2) flows (FIG. 2 (B)). As a result, the concave-convex shape is resolved, and a flat coating film 2 is formed (FIG. 2 (C)). Lastly, the flat coating film 2 can be insolubilized by treatment with heat, light, plasma, or any combination thereof to form a flat organic film 4 (FIG. 2 (D)). On the insolubilized organic film 4, a composition for forming a coating film, such as a composition for forming a silicon-containing resist middle layer film described later, can be applied by spin-coating to form a coating film. Incidentally, in the method of FIG. 2, after forming the coating film 2, the organic solvent contained in the coating film 2 may be removed by treatment with heat, light, plasma, or any combination thereof to such an extent that the coating film 2 does not cure completely.

In the following, each step of the inventive method for forming an organic film will be described in more detail.

### [Step of Forming Coating Film]

In the inventive method for forming an organic film, firstly, a coating film is formed on a substrate having a concave-convex pattern by spin-coating with a composition for forming an organic film. The substrate having the concave-convex pattern is not particularly limited, and for example, it is possible to use a substrate having a trench pattern, a space pattern, a line pattern, etc. In addition, the composition for forming an organic film used in the present invention is not particularly limited, but it is preferable to use a composition for forming an organic film containing a resin containing one or more aromatic rings. Incidentally, the spin-coating is not particularly limited, and can be performed using a spin-coater or the like according to a known method.

In the present invention, after forming the coating film, the organic solvent contained in the coating film may be removed by treatment with heat, light, plasma, or any combination thereof to such an extent that the coating film does not cure completely.

As methods for heat, light, and plasma irradiation, it is possible to use the same techniques as the methods for performing the insolubilization treatment described later. However, from the viewpoint of simplicity and convenience of the process, heat treatment is preferably used, more preferably heat treatment at 50°C or higher and 450°C or lower, further preferably heat treatment at 80°C or higher and 400°C or lower, and particularly preferably heat treatment at 100°C or higher and 350°C or lower.

Resins for forming an organic film usable in the composition for forming an organic film used in the present invention are not particularly limited as long as the resins have sufficient film-formability in spin-coating and curability. From the viewpoints of etching resistance, optical characteristics, heat resistance, etc., a compound including an aromatic skeleton is preferable.

Examples of the aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, carbazole, etc. Among these, benzene, naphthalene, and fluorene are particularly preferable.

Examples of resins for forming an organic film applicable to the present invention include resins containing the following structures, disclosed in JP 2012-1687 A and JP 2012-77295 A.

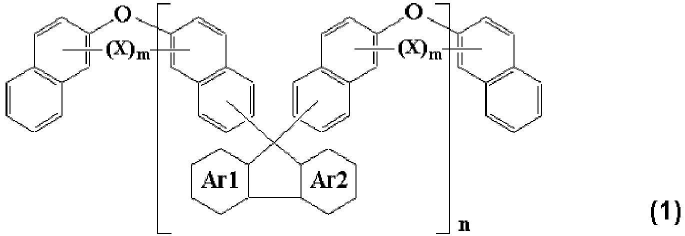

In the formula (1), the cyclic structures Ar1 and Ar2 each represent a benzene ring or a naphthalene ring. X represents a single bond or an alkylene group having 1 to 20 carbon atoms. "m" represents 0 or 1. "n" represents any natural number that provides a molecular weight of 100,000 or less. Note that the symbols in the formula apply only in this formula.

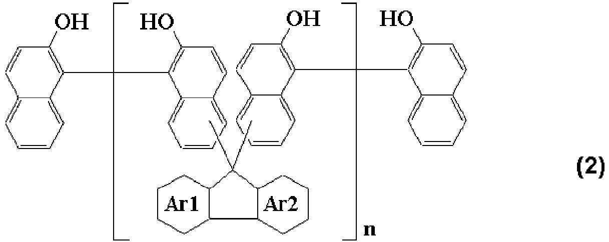

In the formula (2), the cyclic structures Ar1 and Ar2 each represent a benzene ring or a naphthalene ring. "n" represents any natural number that provides a weight-average molecular weight of 100,000 or less as measured by gel permeation chromatography in terms of polystyrene (eluent: THF). Note that the symbols in the formula apply only in this formula.

Further examples of resins for forming an organic film applicable to the present invention include resins containing the following structures, disclosed in JP 2004-264710 A, JP 2005-043471 A, JP 2005-250434 A, JP 2007-293294 A, and JP 2008-65303 A.

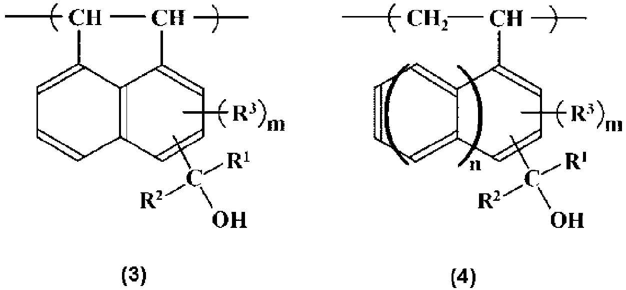

In the formula (3) and the formula (4), R¹ and R² each represent a hydrogen atom, an alkyl group having 1 to 3 carbon atoms, or an aryl group; R³ represents an alkyl group having 1 to 3 carbon atoms, a vinyl group, an allyl group, or an aryl group that is optionally substituted; "n" represents 0 or 1; and "m" represents 0, 1, or 2. Note that the symbols in the formulae apply only in these formulae.

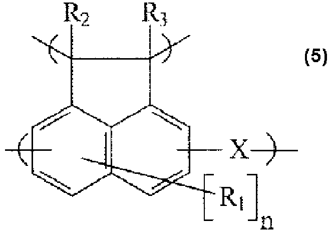

In the formula (5), R₁ represents a monovalent atom other than a hydrogen atom or a monovalent group; and "n" represents an integer of 0 to 4. Here, when "n" is 2 to 4, the multiple R₁'s may be identical to or different from each other. R₂ and R₃ each independently represent a monovalent atom or group. X represents a divalent group. Note that the symbols in the formula apply only in this formula.

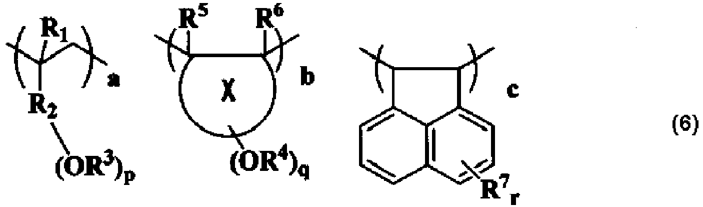

In the formula (6), R₁ represents a hydrogen atom or a methyl group. R₂ represents a single bond, a linear, branched, or cyclic alkylene group having 1 to 20 carbon atoms, or an arylene group having 6 to 10 carbon atoms, and may have any of ether, ester, lactone, and amide. R³ and R⁴ each represent a hydrogen atom or a glycidyl group. X represents any polymer of any of a hydrocarbon including an indene skeleton, a cycloolefin having 3 to 10 carbon atoms, and maleimide, and may have any of ether, ester, lactone, and carboxylic anhydride. R⁵ and R⁶ each represent a hydrogen atom, a fluorine atom, a methyl group, or a trifluoromethyl group. R⁷ represents a hydrogen atom, a linear, branched, or cyclic alkyl group having 1 to 6 carbon atoms, a hydroxy group, or an alkoxycarbonyl group. "p" and "q" each represent an integer of 1 to 4. "r" represents an integer of 0 to 4. "a", "b", and "c" each satisfy 0.5 ≤ a+b+c ≤ 1, 0 ≤ a ≤ 0.8, 0 ≤ b ≤ 0.8, 0.1 ≤ a+b ≤ 0.8, and 0.1 ≤ c ≤ 0.8. Note that the symbols in the formula apply only in this formula.

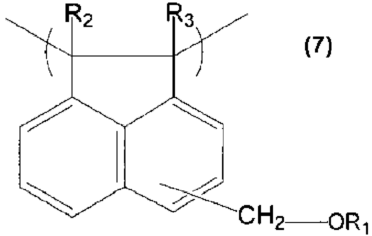

In the formula (7), R₁ represents a hydrogen atom or a monovalent organic group; and R₂ and R₃ each independently represent a monovalent atom or a monovalent organic group. Note that the symbols in the formula apply only in this formula.

Specific examples of resins for forming an organic film applicable to the present invention include resins containing the following structures, disclosed in JP 2004-205685 A, JP 2007-171895 A, and JP 2009-14816 A.

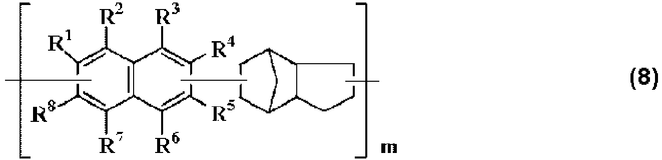

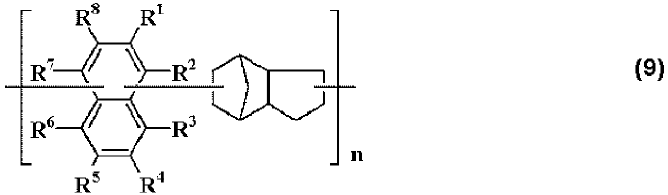

In the formula (8) and the formula (9), R¹ to R⁸ each independently represent a hydrogen atom, a hydroxy group, an alkyl group having 1 to 6 carbon atoms and optionally being substituted, an alkoxy group having 1 to 6 carbon atoms and optionally being substituted, an alkoxycarboxy group having 2 to 6 carbon atoms and optionally being substituted, an aryl group having 6 to 10 carbon atoms and optionally being substituted, a hydroxyalkyl group having 1 to 6 carbon atoms, an isocyanate group, or a glycidyl group. "m" and "n" each represent a positive integer. Note that the symbols in the formulae apply only in these formulae.

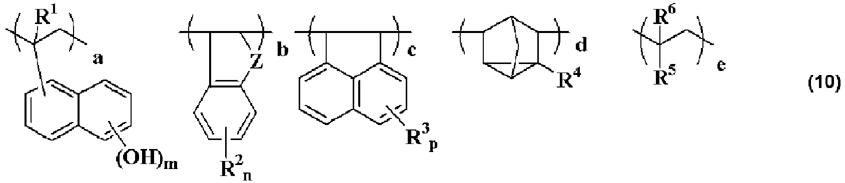

In the formula (10), R¹ and R⁶ each represent a hydrogen atom or a methyl group. R², R³, and R⁴ each represent a hydrogen atom, an alkyl group having 1 to 4 carbon atoms, an alkoxy group, a hydroxy group, an acetoxy group, an alkoxycarbonyl group, or an aryl group having 6 to 10 carbon atoms; R⁵ represents a condensed polycyclic hydrocarbon group having 13 to 30 carbon atoms, -O-R⁷, -C(=O)-O-R⁷, -O-C(=O)-R⁷, or -C(=O)-NR⁸-R⁷; "m" represents 1 or 2; "n" represents an integer of 0 to 4; and "p" represents an integer of 0 to 6. R⁷ represents an organic group having 7 to 30 carbon atoms; R⁸ represents a hydrogen atom or a hydrocarbon group having 1 to 6 carbon atoms. Z represents a methylene group, -O-, -S-, or -NH-. "a", "b", "c", "d", and "e" each satisfy 0 < a < 1.0, 0 ≤ b ≤ 0.8, 0 ≤ c ≤ 0.8, 0 ≤ d ≤ 0.8, 0 ≤ e ≤ 0.8, and 0 < b+c+d+e < 1.0. Note that the symbols in the formula apply only in this formula.

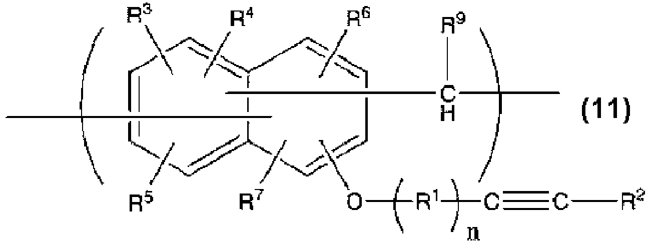

In the formula (11), "n" represents 0 or 1. R¹ represents a methylene group that is optionally substituted, an alkylene group having 2 to 20 carbon atoms and optionally being substituted, or an arylene group having 6 to 20 carbon atoms and optionally being substituted. R² represents a hydrogen atom, an alkyl group having 1 to 20 carbon atoms and optionally being substituted, or an aryl group having 6 to 20 carbon atoms and optionally being substituted. R³ to R⁷ each represent a hydroxy group, an alkyl group having 1 to 6 carbon atoms and optionally being substituted, an alkoxy group having 1 to 6 carbon atoms and optionally being substituted, an alkoxycarbonyl group having 2 to 10 carbon atoms and optionally being substituted, an aryl group having 6 to 14 carbon atoms and optionally being substituted, or a glycidyl ether group having 2 to 6 carbon atoms and optionally being substituted. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. Note that the symbols in the formula apply only in this formula.

Examples include the following compounds.

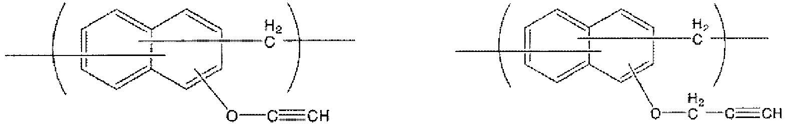

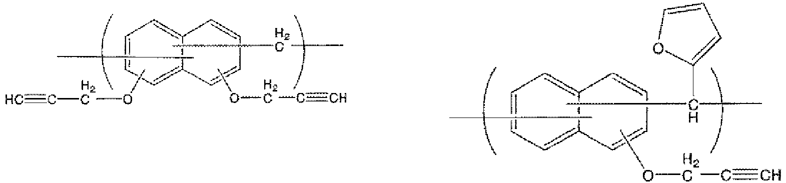

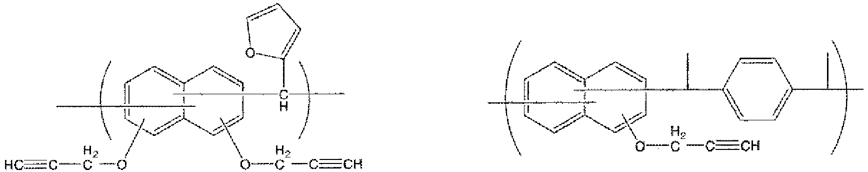

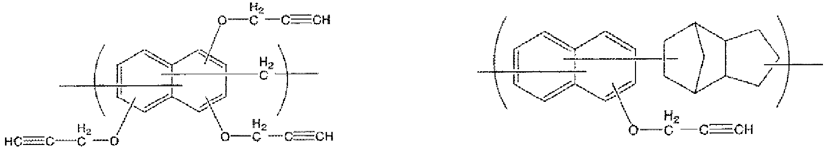

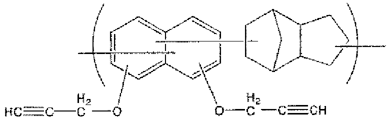

Examples of resins for forming an organic film applicable to the present invention include resins containing the following structures, disclosed in JP 2007-199653 A, JP 2008-274250 A, and JP 2010-122656 A.

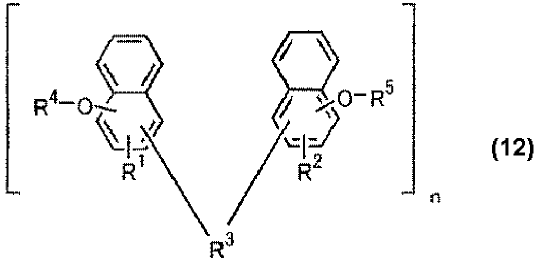

In the formula (12), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and "n" represents an integer of 1 to 4. Note that the symbols in the formula apply only in this formula.

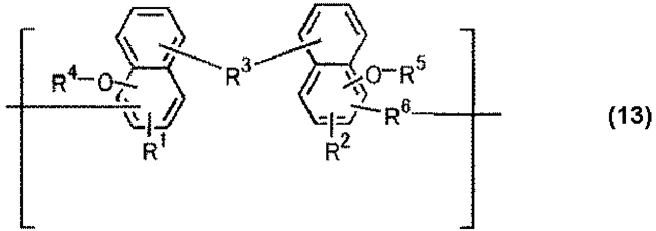

In the formula (13), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and R⁶ represents a single bond or a linear or branched alkylene group having 1 to 10 carbon atoms. Note that the symbols in the formula apply only in this formula.

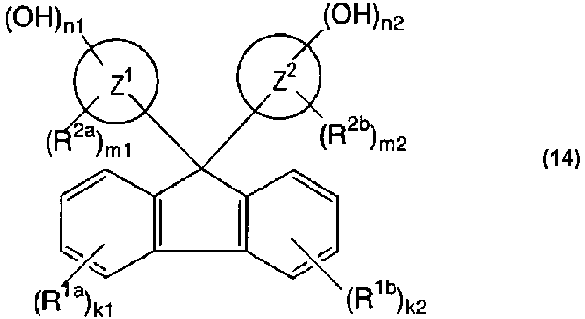

In the formula (14), the ring Z¹ and the ring Z² each represent a condensed polycyclic aromatic hydrocarbon ring; and R^{1a}, R^{1b}, R^{2a}, and R^{2b} are identical to or different from each other and each represent a substituent. "k1" and "k2" may be identical to or different from each other and each represent 0 or an integer of 1 to 4; "m1" and "m2" each represent 0 or an integer of 1 or more; and "n1" and "n2" each independently represent 0 or an integer of 1 or more. Here, n1+n2 ≥ 1. Note that the symbols in the formula apply only in this formula.

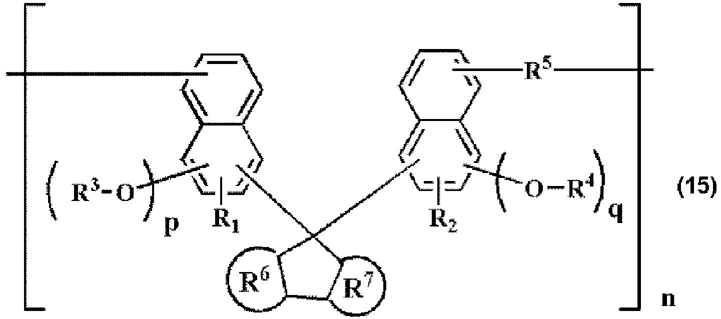

In the formula (15), R₁ and R₂ are identical to or different from each other, and each represent a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ each represent a hydrogen atom or a glycidyl group; R⁵ represents a single bond or a linear or branched alkylene group having 1 to 10 carbon atoms; and R⁶ and R⁷ each represent a benzene ring or a naphthalene ring. "p" and "q" each represent 1 or 2. "n" satisfies 0 < n ≤ 1. Note that the symbols in the formula apply only in this formula.

Examples include the following compounds.

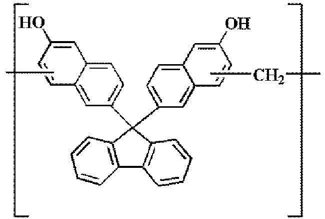

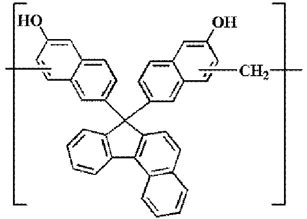

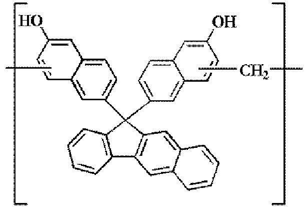

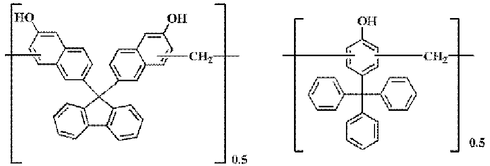

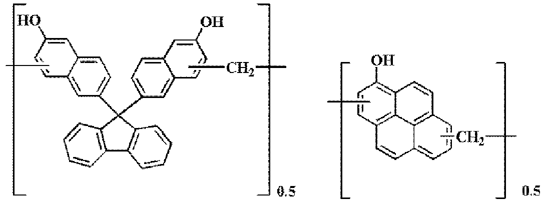

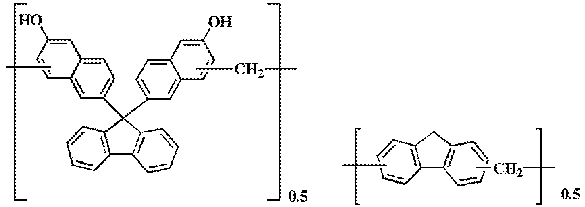

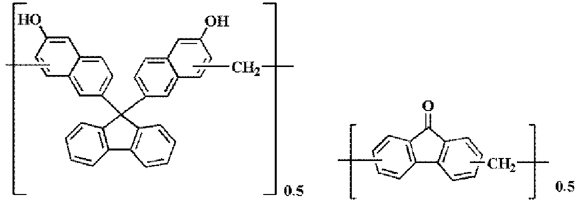

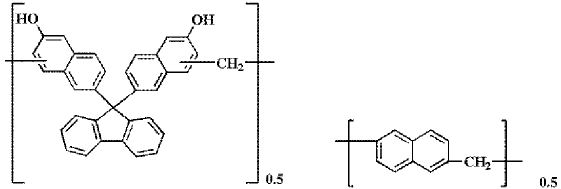

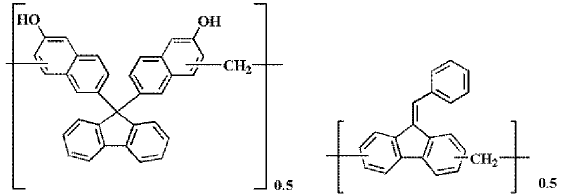

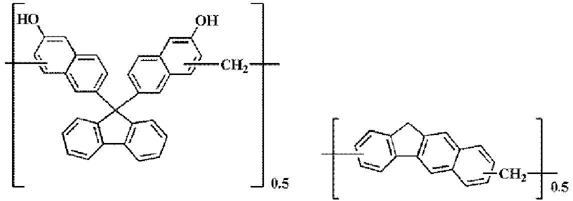

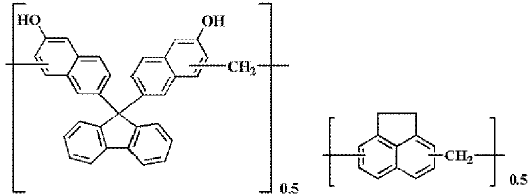

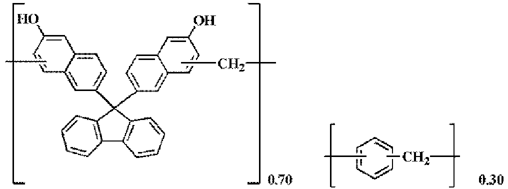

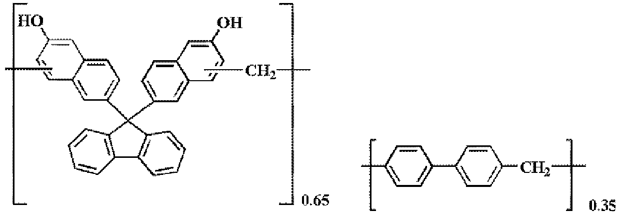

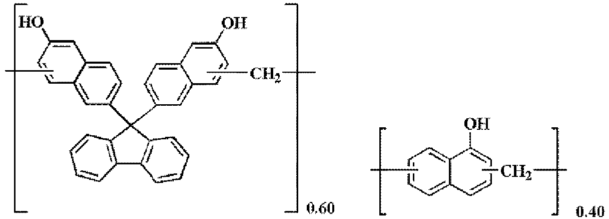

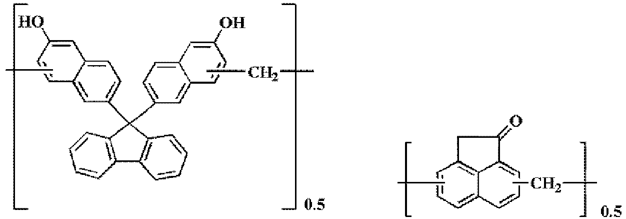

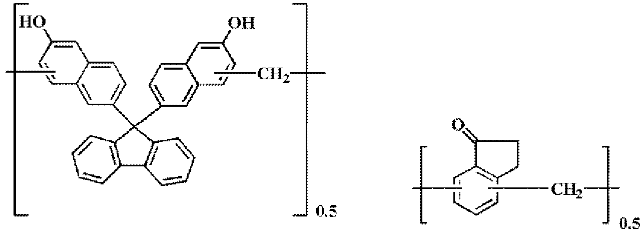

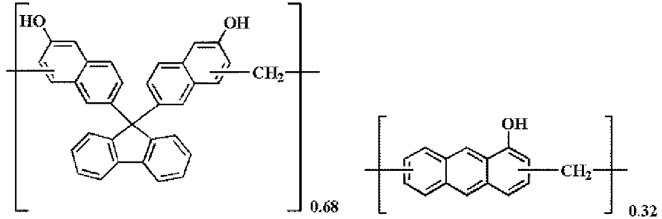

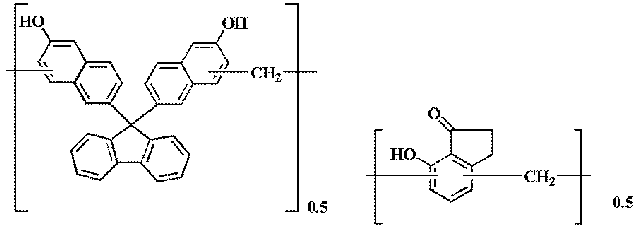

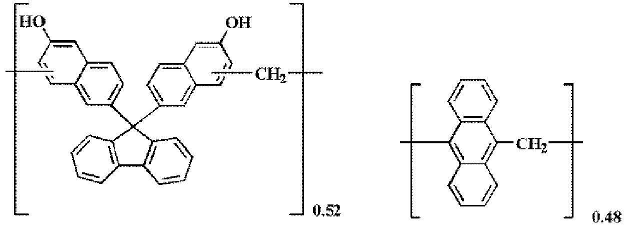

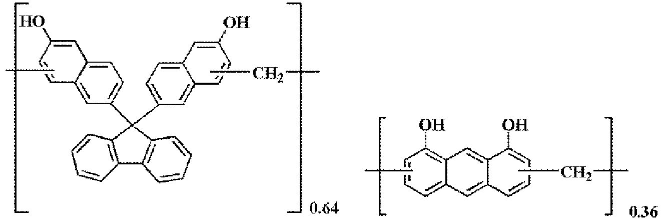

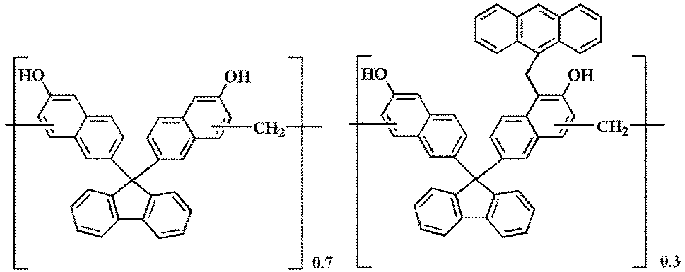

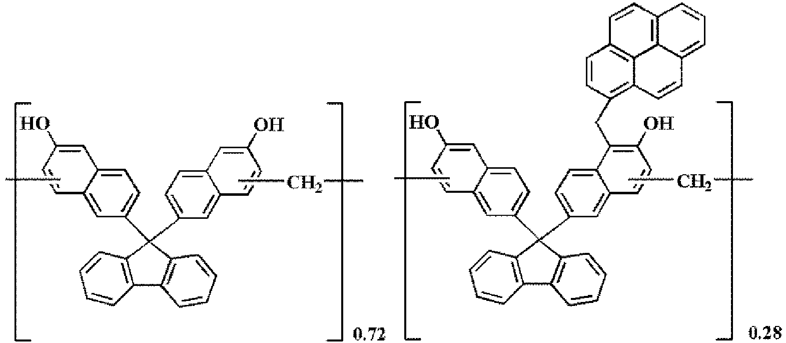

Examples of resins for forming an organic film applicable to the present invention include resins containing the following structure, disclosed in JP 2012-214720 A.

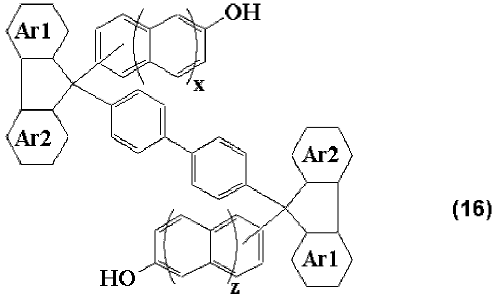

In the formula (16), the cyclic structures Ar1 and Ar2 each represent a benzene ring or a naphthalene ring. "x" and "z" each independently represent 0 or 1. Note that the symbols in the formula apply only in this formula.

Examples of resins for forming an organic film applicable to the present invention include resins disclosed in JP 2014-29435 A, WO 2012/077640 A1, and WO 2010/147155 A1.

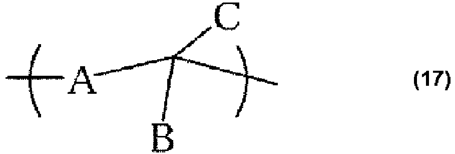

In the formula (17), A represents a structure having carbazole, B represents a structure having an aromatic ring, and C represents a hydrogen atom, an alkyl group, or a structure having an aromatic ring, B and C optionally constituting a ring with each other. One to four carboxy groups, a salt thereof, or a carboxylic acid ester group is contained in the combined structure of A, B, and C. Note that the symbols in the formula apply only in this formula.

Further examples include polymers disclosed in WO 2012/077640 A1, the polymers containing a unit structure represented by the following formula (18) and a unit structure represented by the following formula (19), where the ratio of the unit structure represented by the formula (18) to the unit structure represented by the formula (19) is 3 to 97 : 97 to 3 by molar ratio.

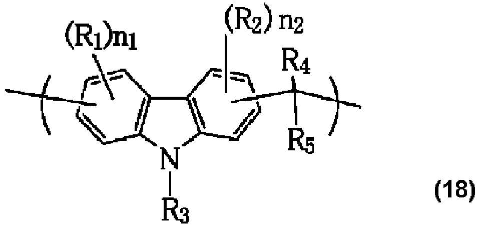

In the formula (18), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₃ represents a hydrogen atom, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₄ represents a hydrogen atom, or an aryl group or heterocyclic group having 6 to 40 carbon atoms and optionally being substituted with a halogen atom, a nitro group, an amino group, or a hydroxy group; R₅ represents a hydrogen atom, or an alkyl group having 1 to 10 carbon atoms, aryl group having 6 to 40 carbon atoms, or heterocyclic group optionally substituted with a halogen atom, a nitro group, an amino group or a hydroxy group; and R₄ and R₅ may form a ring with each other. "n1" and "n2" each represent an integer of 1 to 3. Note that the symbols in the formula apply only in this formula.

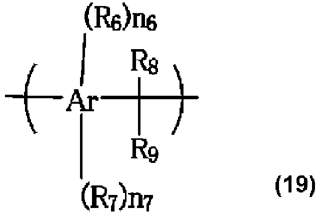

In the formula (19), Ar represents an aromatic ring group having 6 to 20 carbon atoms; R₆ represents a hydroxy group; and R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₈ represents a hydrogen atom, or an aryl group or heterocyclic group having 6 to 40 carbon atoms and optionally substituted with a halogen atom, a nitro group, an amino group, or a hydroxy group; R₉ represents a hydrogen atom, or an alkyl group having 1 to 10 carbon atoms optionally substituted with a halogen atom, a nitro group, an amino group, or a hydroxy group, an aryl group having 6 to 40 carbon atoms optionally substituted with a halogen atom, a nitro group, an amino group, or a hydroxy group, or a heterocyclic group optionally substituted with a halogen atom, a nitro group, an amino group, or a hydroxy group; and R₈ and R₉ may form a ring with each other. "n6" represents an integer of 1 to "p", "n7" represents an integer of p-n6. Here, "p" is the maximum number of substituents with which the aromatic ring group Ar can be substituted. Note that the symbols in the formula apply only in this formula.

Examples of resins for forming an organic film applicable to the present invention include polymers containing a unit structure represented by the following formula (20), disclosed in WO 2010/147155 A1.

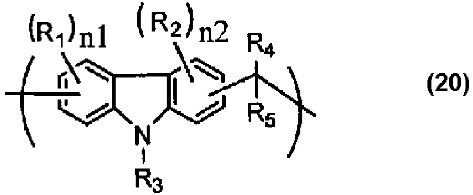

In the formula (20), R₁ and R₂ are each selected from the group consisting of a hydrogen atom, a halogen group, a nitro group, an amino group, a hydroxy group, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₃ is selected from the group consisting of a hydrogen atom, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₄ represents an aryl group or heterocyclic group having 6 to 40 carbon atoms and optionally substituted with a halogen group, a nitro group, an amino group, or a hydroxy group; R₅ represents a hydrogen atom or an alkyl group having 1 to 10 carbon atoms or an aryl group or heterocyclic group having 6 to 40 carbon atoms and optionally substituted with a halogen group, a nitro group, an amino group, or a hydroxy group; R₄ and R₅ optionally form a ring together with the carbon atom bonded to R₄ and R₅; and "n1" and "n2" each represent an integer of 1 to 3. Note that the symbols in the formula apply only in this formula.

Examples of resins for forming an organic film applicable to the present invention include: novolak resins obtained by a reaction between one or more phenols, such as phenol, cresol, xylenol, catechol, resorcinol, hydroquinone, pyrogallol, hydroxyquinol, and phloroglucinol, and one or more aldehyde sources, such as formaldehyde, paraformaldehyde, and trioxane, in the presence of an acid catalyst; and resins containing a repeating unit structure represented by the following formula (21), disclosed in WO 2012/176767 A1.

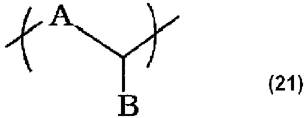

In the formula (21), A represents a hydroxy group-substituted phenylene group derived from polyhydroxybenzene; and B represents a monovalent condensed aromatic hydrocarbon ring group in which two to six benzene rings are condensed. Note that the symbols in the formula apply only in this formula.

Examples of resins for forming an organic film applicable to the present invention include novolak resins having a fluorene or tetrahydrospirobiindene structure, disclosed in JP 2005-128509 A, JP 2006-259249 A, JP 2006-259482 A, JP 2006-293298 A, and JP 2007-316282 A, the novolak resins containing a repeating unit structure represented by the following formula (22-1) or (22-2).

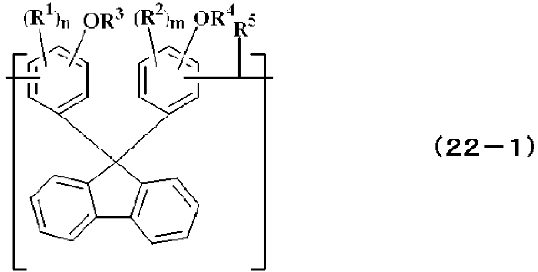

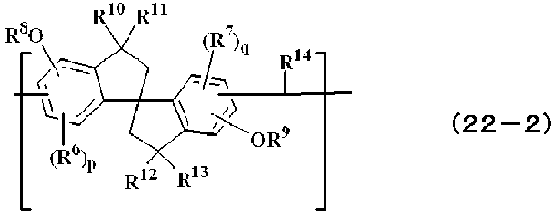

In the formula (22-1) and the formula (22-2), R¹, R², R⁶, and R⁷ each independently represent a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ each independently represent a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; and R⁵ and R¹⁴ each independently represent a hydrogen atom, a linear, branched, or cyclic alkyl group having 1 to 10 carbon atoms, or an aryl group having 6 to 10 carbon atoms. "n", "m", "p", and "q" each represent an integer of 1 to 3. R¹⁰ to R¹³ each independently represent a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. Note that the symbols in the formulae apply only in these formulae.

Examples of resins for forming an organic film applicable to the present invention include reaction products obtained by a method disclosed in JP 2012-145897 A.

More specific examples include polymers obtained by condensing one or more compounds represented by the following general formula (23-1) and/or (23-2) and one or more compounds represented by the following general formula (24-1) and/or (24-2) and/or an equivalent thereof.

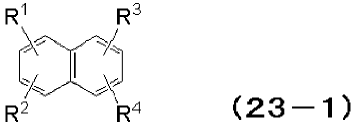

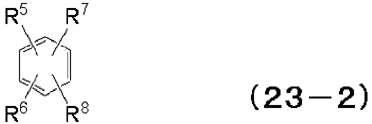

In the formula (23-1) and the formula (23-2), R¹ to R⁸ each independently represent a hydrogen atom, a halogen atom, a hydroxy group, an isocyanato group, a glycidyloxy group, a carboxy group, an amino group, an alkoxy group having 1 to 30 carbon atoms, an alkoxycarbonyl group having 1 to 30 carbon atoms, an alkanoyloxy group having 1 to 30 carbon atoms, or a saturated or unsaturated organic group having 1 to 30 carbon atoms and optionally being substituted. Furthermore, any two substituents selected from each of **R¹** to R⁴ or R⁵ to R⁸ may be bonded to each other within a molecule to form a cyclic substituent. Note that the symbols in the formulae apply only in these formulae.

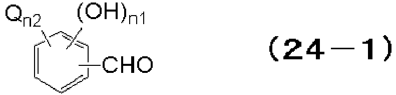

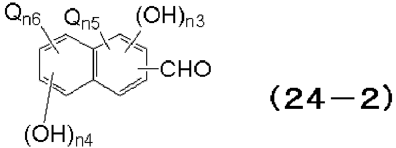

In the formula (24-1) and the formula (24-2), Q represents an organic group having 1 to 30 carbon atoms and optionally being substituted, and furthermore, any two Q's selected therefrom are optionally bonded with each other within a molecule to form a cyclic substituent. "n1" to "n6" each represent the number of each substituent, "n1" to "n6" are each independently 0, 1, or 2, and in the formula (24-1), hydroxybenzaldehyde is excluded. Meanwhile, in the formula (24-2), the relationships 0 ≤ n3+n5 ≤ 3, 0 ≤ n4+n6 ≤ 4, and 1 ≤ n3+n4 ≤ 4 are satisfied. Note that the symbols in the formulae apply only in these formulae.

Further examples also include polymers obtained by condensing one or more compounds represented by the general formula (23-1) and/or (23-2), one or more compounds represented by the general formula (24-1) and/or (24-2) and/or an equivalent thereof, and one or more compounds represented by the following general formula (25) and/or an equivalent thereof.

Y-CHO (25)

In the formula (25), Y represents a hydrogen atom or a monovalent organic group having 30 or fewer carbon atoms and optionally having a substituent, and the formula (25) is different from the formula (24-1) and the formula (24-2). Note that the symbol in the formula applies only in this formula.

Examples of resins for forming an organic film applicable to the present invention include resins containing the following structure, disclosed in JP 2017-119671 A.

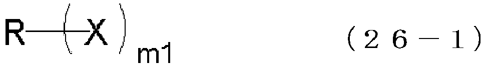

In the formula (26-1), R represents a single bond or an organic group having 1 to 50 carbon atoms; X represents a group represented by any of the following general formulae (26-2); and "m1" represents an integer that satisfies 2 ≤ m1 ≤ 10. Note that the symbols in the formula apply only in this formula.

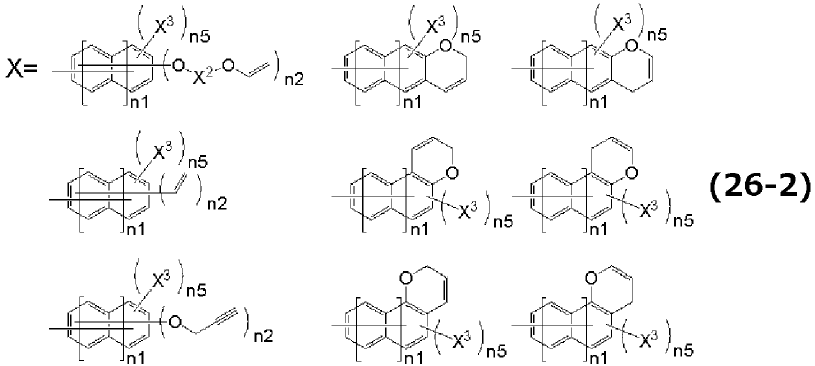

In the formulae, X² represents a divalent organic group having 1 to 10 carbon atoms; "n1" represents 0 or 1; "n2" represents 1 or 2; X³ represents a group represented by the following general formula (26-3); and "n5" represents 0, 1, or 2. Note that the symbols in the formulae apply only in these formulae.

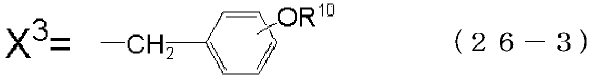

In the formula, R¹⁰ represents a hydrogen atom or a saturated or unsaturated hydrocarbon group having 1 to 10 carbon atoms, and a hydrogen atom on the benzene ring in the formula may be substituted with a methyl group or a methoxy group. Note that the symbol in the formula applies only in this formula.

Examples include the following compounds.

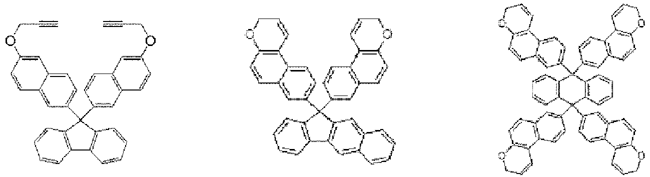

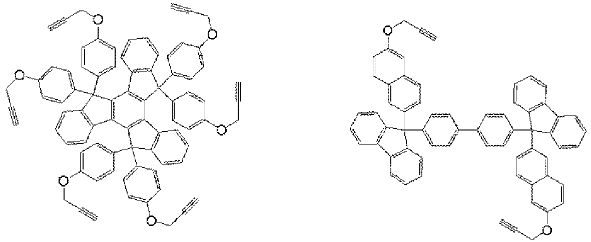

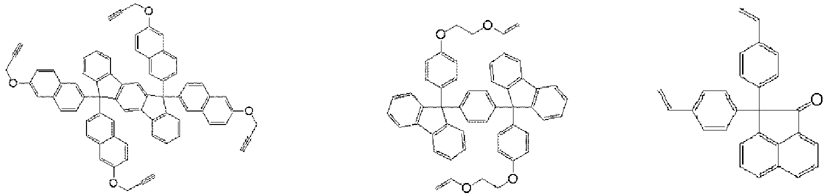

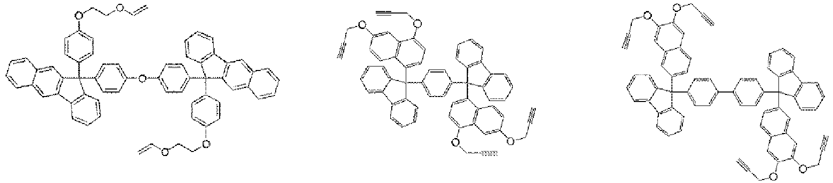

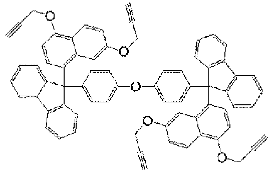

Examples of resins for forming an organic film applicable to the present invention include polymers having a repeating unit represented by the following general formula (27-1), disclosed in JP 2019-44022 A.

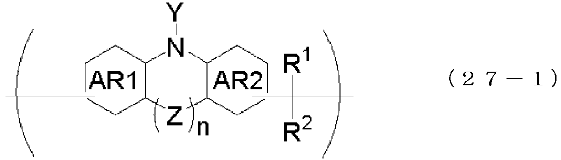

In the formula (27-1), AR1 and AR2 each represent a benzene ring or naphthalene ring optionally having a substituent. R¹ and R² each independently represent a hydrogen atom or an organic group having 1 to 30 carbon atoms, and when R¹ and R² each represent an organic group, R¹ and R² are optionally bonded to each other within a molecule to form a cyclic organic group. "n" represents 0 or 1; when n = 0, AR1 and AR2 do not form a bridged structure between the aromatic rings of AR1 and AR2 via Z; when n = 1, AR1 and AR2 form a bridged structure between the aromatic rings of AR1 and AR2 via Z; and Z represents a single bond or one of the following formulae (27-2). Y represents a group represented by the following formula (27-3). Note that the symbols in the formula apply only in this formula.

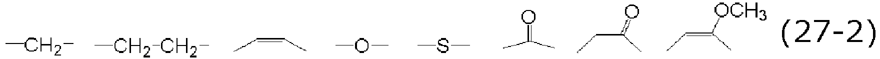

**-R³-C≡C-R⁴** (27 - 3)

In the formula, R³ represents a single bond or a divalent organic group having 1 to 20 carbon atoms; R⁴ represents a hydrogen atom or a monovalent organic group having 1 to 20 carbon atoms; and a broken line represents an attachment point. Note that the symbols in the formula apply only in this formula.

Examples include the following polymers.

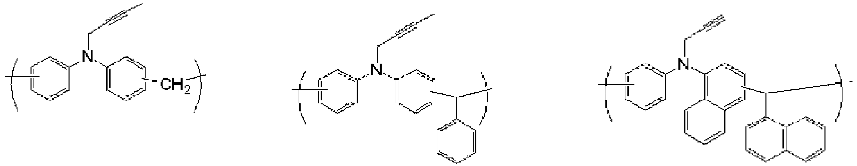

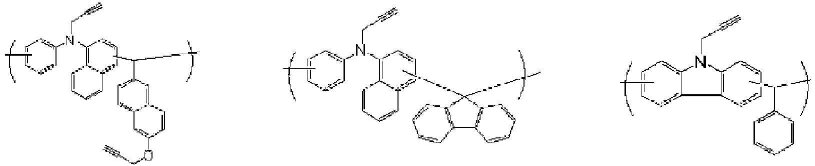

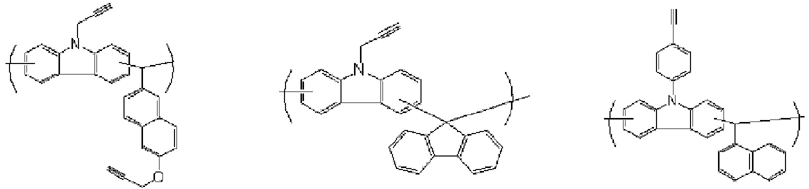

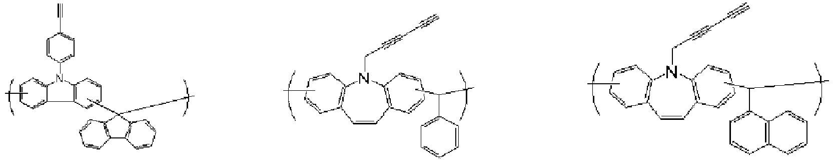

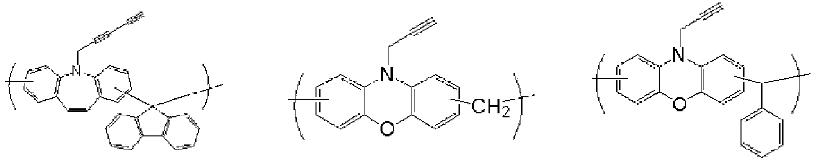

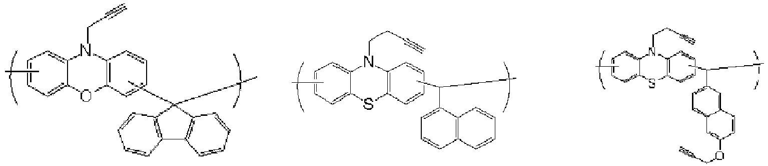

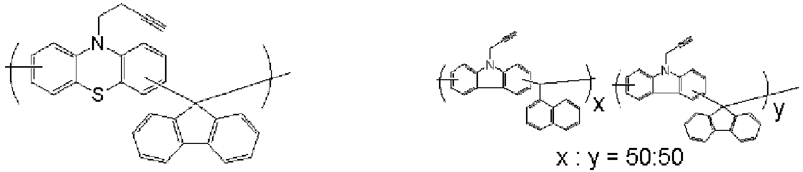

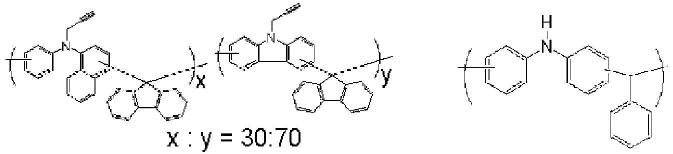

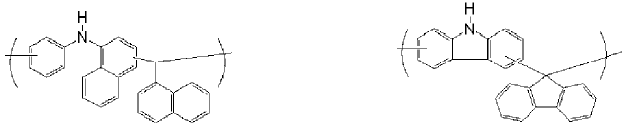

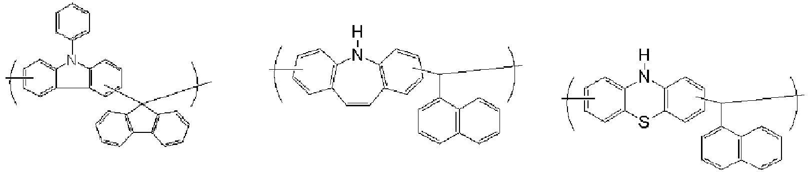

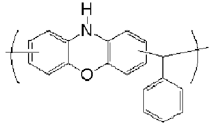

The resin for forming an organic film may be synthesized by a known method, and a commercially available product may be used.

The resin for forming an organic film is preferably contained in an amount of, for example, 0.2 to 50 parts by mass, more preferably 1 to 33.3 parts by mass, based on 100 parts by mass of the composition for forming an organic film.

The composition for forming an organic film may contain a resin for forming an organic film and a solvent, and in addition, may contain additives such as a crosslinking agent, an acid generator, or a surfactant.

Solvents usable in the composition for forming an organic film are not particularly limited as long as they are capable of dissolving the resin for forming an organic film, and the solvents are preferably also capable of dissolving acid generators, crosslinking agents, surfactants, etc., described later. Specific examples of solvents include: ketones, such as 2-heptanone, cyclopentanone, and cyclohexanone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, γ-butyrolactone, and propylene glycol mono-tert-butyl ether acetate. One of the solvents may be used or a mixture of two or more kinds may be used, and the solvents are not limited thereto.

In particular, preferable solvents are propylene glycol monomethyl ether acetate, propylene glycol monomethyl ether, 2-heptanone, cyclopentanone, cyclohexanone, γ-butyrolactone, and mixtures of two or more thereof.

As a usable solvent, a solvent having a normal boiling point of 80°C or higher and lower than 160°C can be adopted.

The solvent is preferably contained in an amount of 100 to 50,000 parts by mass, more preferably 200 to 10,000 parts by mass based on 100 parts by mass of the resin for forming an organic film.

### [Other Components]

In addition, the composition for forming an organic film can contain an acid generator, a crosslinking agent, etc. for further promoting the crosslinking reaction.

Acid generators include materials that generate an acid by thermal decomposition and materials that generate an acid by light irradiation, and any acid generator can be contained. Specific examples of the acid generator include those disclosed in paragraphs (0061) to (0085) of JP 2007-199653 A.

The amount of the acid generator to be contained is not particularly limited, but can be, for example, 0.05 to 50 parts by mass based on 100 parts by mass of the resin for forming an organic film.

Specific examples of the crosslinking agent include those disclosed in paragraphs (0055) to (0060) of JP 2007-199653 A.

The amount of the crosslinking agent to be contained is not particularly limited, but for example, can be 1 to 50 parts by mass based on 100 parts by mass of the resin for forming an organic film.

The composition for forming an organic film can also contain a surfactant in order to improve coating property in spin-coating. Specific examples of the surfactant include those disclosed in paragraphs (0142) to (0147) of JP 2009-269953 A.

The amount of the surfactant to be contained is not particularly limited, but for example, can be 0.001 to 20 parts by mass based on 100 parts by mass of the resin for forming an organic film.

The composition for forming an organic film can further contain a basic compound for enhancing storage stability. The basic compound serves as a quencher to an acid to prevent a very small amount of acid generated by the acid generator from promoting the crosslinking reaction. Specific examples of such a basic compound include those disclosed in paragraphs (0086) to (0090) of JP 2007-199653 A.

### [Step of Applying Coating Solvent]

In the inventive method for forming an organic film, after forming the coating film, a treatment of spin-coating the coating film with a coating solvent having a normal boiling point of 160°C or higher and lower than 500°C is performed before the insolubilization treatment. Methods for applying the coating solvent are not particularly limited, and a known method can be performed using a spin-coater or the like. Incidentally, as the spin-coating method, either static dispense or dynamic dispense can be adopted.

It is thought that, in the inventive method for forming an organic film, the coating film before the insolubilization treatment dissolves in the coating solvent and the resin component in the uncured coating film can achieve sufficient thermal flowability, and therefore, it is possible to form a resist underlayer film excellent in filling and planarizing properties. Therefore, the coating film before the insolubilization treatment needs to be soluble in the coating solvent. Specifically, when "a" is the film thickness of a coating film before the insolubilization treatment formed on a substrate having no concave-convex patterns by spin-coating using the composition for forming an organic film, and "b" is the film thickness of an organic film formed by performing a heat treatment at 100°C for 60 seconds after spin-coating the coating film with the coating solvent, the upper limit of the ratio b/a is preferably 99.5%, more preferably 99%, and further preferably 98%. The lower limit of the ratio b/a is preferably 30%, more preferably 40%, and further preferably 50%.

When the coating film before the insolubilization treatment dissolves in the coating solvent in the above-described ranges, the resin component contained in the coating film can achieve sufficient thermal flowability. When the upper limit of the ratio b/a is 99.5%, the resin component contained in the coating film can achieve sufficient thermal flowability, and when the lower limit of the ratio b/a is 30%, excessive thinning of the film can be suppressed, and therefore, such a limit is preferable from the viewpoint of saving resist.

The coating solvent is an organic solvent having a normal boiling point of 160°C or higher and lower than 500°C, may be liquid when used in the step of applying the coating solvent, and is preferably liquid at room temperature (25°C).

The coating solvent is not particularly limited to alcohols, esters, ketones, carbonates, ethers, amides, or chlorine-based solvents, but from the viewpoint of compatibility with the coating film, alcohols, esters, ketones, carbonates, ethers, and combinations thereof are preferable. Specific examples include: alcohols, such as 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, and glycerin; ethers, such as monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, and tripropylene glycol mono-n-butyl ether; esters, such as n-nonyl acetate, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, and dibutyl adipate; ketones, such as ethyl amyl ketone, dibutyl ketone, and diamyl ketone; and carbonates, such as ethylene carbonate and propylene carbonate. One of the solvents may be used or a mixture of two or more kinds may be used.

The normal boiling point of the coating solvent needs to be 160°C or higher and lower than 500°C, may be 180°C or higher, and is preferably 200°C or higher and 400°C or lower. If the boiling point is outside the above-described boiling point range, the resin component in the uncured coating film cannot achieve sufficient thermal flowability, and it is not possible to form a resist underlayer film having excellent filling and planarizing properties. In addition, when the boiling point is as described, the coating solvent does not remain in the film without evaporating after the insolubilization treatment is performed, and therefore, there is no risk of the solvent adversely affecting the physical properties, such as etching resistance, of the film.

The coating solvent may be different from or the same as an organic solvent (derived from an organic solvent contained in the composition for forming an organic film) contained in the coating film, but preferably has a normal boiling point higher than the normal boiling point of the organic solvent contained in the coating film. Such a coating solvent evaporates less easily than the organic solvent contained in the coating film, and therefore, during an insolubilization treatment, the resin component in the uncured coating film exhibits suitable thermal flowability, and it is possible to form a film having better filling and planarizing properties.

In view of solubility and wettability regarding the organic film and so forth, an aromatic group-containing compound having a benzyl group or a benzoyl group is preferable.

In particular, the following aromatic group-containing compounds are preferable.
(i) (Poly)ethylene glycol dibenzoate
(ii) (Poly)ethylene glycol dibenzyl ether
(iii) (Poly)propylene glycol dibenzyl ether
(iv) (Poly)butylene glycol dibenzyl ether
(v) Linear aliphatic dibenzyl dicarboxylate
(vi) (Poly)ethylene glycol monobenzyl ether
(vii) (Poly)phenyl ether
(viii) Alkylbenzyl phthalate

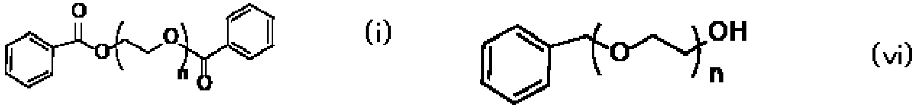

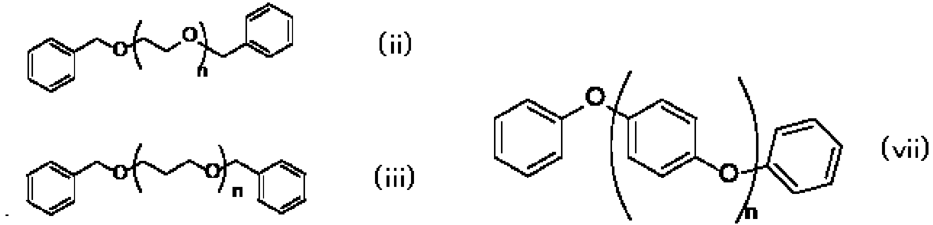

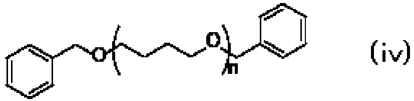

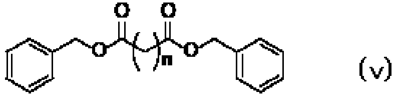

Note that the "n" in the formulae represents an integer that provides a molecular weight of 150 to 500, and applies only in these formulae.

The applied amount of the coating solvent when the coating solvent is applied to the coating film is not particularly limited, and is preferably 0.5 ml or more and 20 ml or less, more preferably 1 ml or more and 15 ml or less, and further preferably 1.5 ml or more and 10 ml or less.

### [Step of Forming Organic Film]

The step of forming an organic film is a step of forming an organic film by subjecting the coating film to an insolubilization treatment against the coating solvent following the step of applying coating solvent.

In the inventive method for forming an organic film, the coating film before the insolubilization treatment is in an uncured or incompletely cured state, and by the resin component in the coating film dissolving in the coating solvent, the resin component in the uncured or incompletely cured coating film can achieve sufficient thermal flowability. In contrast, the coating film after the insolubilization treatment is in a cured state, and the resin component in the coating film does not dissolve in the coating solvent and does not have thermal flowability. Thus, the organic film is formed. Note that, as stated above, the method for applying the coating solvent is not particularly limited, and both static dispensing and dynamic dispensing can be employed.

### [Insolubilization Treatment]

In the inventive method for forming an organic film, after the coating film is formed, the coating film is subjected to an insolubilization treatment against the coating solvent. The insolubilization treatment makes the resin component in the coating film insoluble in the coating solvent, and is not particularly limited, but is preferably any of a heat treatment at 100°C or higher and 600°C or lower, an irradiation treatment with an ultraviolet ray having a wavelength of 400 nm or less (light treatment), an irradiation treatment with an electron beam (electron beam treatment), and an irradiation treatment with plasma (plasma treatment), or a combination thereof. By performing the insolubilization treatment by such means, it is possible to form an organic film that maintains a flat state.

### [Heat Treatment]

The heat treatment is performed at a temperature of 100°C or higher and 600°C or lower, preferably 150°C or higher and 550°C or lower, more preferably 180°C or higher and 500°C or lower for 10 seconds to 600 seconds, preferably 10 to 300 seconds. By appropriately adjusting the baking temperature and time within the above-described ranges, it is possible to achieve the planarizing and filling properties and curing properties, such as dry etching resistance and heat resistance property, suitable for the intended purpose. When the baking temperature is 100°C or higher, the curing progresses sufficiently, and there is no risk of mixing with a resist upper layer film or a resist middle layer film occurring. When the baking temperature is 600°C or lower, thermal decomposition of the base resin can be suppressed, so that the film thickness does not decrease, and a uniform film surface can be achieved.

As the atmosphere during the baking, either an oxygen-containing atmosphere (oxygen concentration: 1% to 21%), such as air, or a non-oxygen atmosphere, such as nitrogen, can be selected as necessary. For example, if the substrate to be processed is easily oxidized in air, substrate damage can be suppressed by performing the heat treatment in an atmosphere having an oxygen concentration of less than 1% to form the cured film. Incidentally, the unit is volume%.

### [Light Treatment]

The exposure light used in the light treatment is a chemical ray, such as a near ultraviolet ray, a far ultraviolet ray, or an extreme ultraviolet ray (e.g. EUV, having a wavelength of 13.5 nm), and for example, light having a wavelength of 248 nm (KrF laser beam), 193 nm (ArF laser beam), 172 nm (xenon excimer beam), 157 nm (F₂ laser beam), etc. can be used. Furthermore, regarding the exposure wavelength, ultraviolet light having a wavelength of 400 nm or less, in particular, 10 nm to 380 nm can be used, and wavelengths of 10 to 200 nm can be used favorably.

By this exposure, crosslinking of the resin contained in the coating film is carried out. The exposure dose is preferably 10 mJ/cm² to 10,000 mJ/cm². Photoreaction occurs with the exposure dose in this range, crosslinking is formed, and resistance to organic solvents is generated.

### [Electron Beam Treatment]

For the electron beam irradiation, a known method can be used.

Examples include a method disclosed in "Electron Beam Irradiator - Its Technology and Application" (July 2012, SEI Technical Review, Vol. 181, p. 50-57, Non Patent Document). The acceleration voltage can be selected from 2 to 200 kV. The irradiation dose can be selected from 100 to 5,000 kGy. A method in which irradiation with an electron beam is performed while heating is suitable. In this event, the temperature can be selected from 80 to 800°C (preferably 200 to 700°C, more preferably 300 to 600°C). Ion irradiation can be performed according to a known method. Examples include a method disclosed in "Raman spectroscopy and microhardness of ion-implanted a-C:H-films" (Ceramics Int.26 (1), 2000, p. 29-32, Non Patent Document). A suitable embodiment of ion irradiation in the present invention is ion implantation. Examples of elements of the ions to be used for irradiation include hydrogen, boron, carbon, nitrogen, and rare gases; preferably boron, carbon, nitrogen, neon, and argon; and further preferably carbon and nitrogen. Two or more of these gases may be used in mixture. The acceleration voltage can be selected from 3 to 1000 kV. The acceleration voltage is more preferably 5 to 750 kV, further preferably 10 to 500 kV. The irradiation dose can be selected from 10¹³ to 10¹⁸ ion/cm². The irradiation dose is more preferably 5×10¹³ to 5×10¹⁷ ion/cm², further preferably 10¹⁴ to 10¹⁷ ion/cm². The ion irradiation can also be performed while heating the inside of the apparatus chamber. In this event, the temperature can be selected from 500°C or lower. When heating is to be performed after the plasma irradiation or the electron beam irradiation, as heating conditions, the heating temperature can be selected appropriately from the range of 80 to 800°C (preferably 200 to 700°C, more preferably 300 to 600°C), and the heating time from the range of 30 to 180 seconds (preferably 30 to 120 seconds). Without wishing to be bound by any theory, it is considered that, by performing high-temperature heating after the plasma and electron beam irradiation, dangling bonds are bonded to each other, and this can contribute to higher density of the cured film.

As the irradiation apparatus, Tactras Vigus, EB-ENGINE (HAMAMATSU PHOTONICS K.K.), and EXCEED2300AH (Nissin Ion Equipment Co., Ltd.) are usable. It is possible to select an apparatus and set conditions in such a manner as to achieve the advantageous effects of the present invention.

### [Plasma Treatment]

For the plasma irradiation, a known method can be used. Examples include methods disclosed in JP 5746670 B2 and "Improvement of the wiggling profile of spin-on carbon hard mask by H2 plasma treatment" (J. Vac. Sci. Technol. B26 (1), Jan/Feb 2008, p. 67-71).

RF discharge power is preferably 100 to 10,000 W, more preferably 500 to 5,000 W.

Examples of the gas atmosphere include N₂, NF₃, H₂, rare gases such as He, and fluorocarbon; and more suitable examples include He, Ar, N₂, Ne, NF₃, H₂, CF₄, CHF₃, CH₂F₂, CH₃F, C₄F₆, C₄F₈, etc. These gases may be used as a mixture of two or more kinds. An advantage of the present invention is that the advantageous effects of the present invention can be expected even when using a gas atmosphere not containing O₂.

The time of the plasma irradiation can be selected from, for example, 10 to 240 seconds. The pressure can be selected appropriately.

The plasma irradiation is preferably performed under an atmosphere of N₂, NF₃, H₂, fluorocarbon, a rare gas such as He, or a mixture of any thereof.

From the viewpoint of productivity, examples of particularly favorable gas atmospheres include He, Ar, N₂, H₂, etc.

A heat treatment may be performed before or after the plasma irradiation. When heating is to be performed before the plasma irradiation, as heating conditions, the heating temperature can be selected appropriately from the range of 80 to 400°C (preferably 100 to 350°C, more preferably 150 to 300°C), and the heating time from the range of 30 to 180 seconds (preferably 30 to 120 seconds). By heating before the plasma irradiation, the coating solvent contained in the coating film can be removed. When heating is to be performed after the plasma irradiation, as heating conditions, the heating temperature can be selected appropriately from the range of 80 to 800°C (preferably 100 to 700°C, more preferably 200 to 600°C), and the heating time from the range of 30 to 180 seconds (preferably 30 to 120 seconds). Without wishing to be bound by any theory, it is considered that, by performing high-temperature heating after the plasma irradiation, dangling bonds are bonded to each other, and this can contribute to higher density of the cured film (resist underlayer film).

As the atmosphere during the heating after the plasma irradiation, it is possible to select, as necessary, an oxygen-containing atmosphere (oxygen concentration: 1 volume % to 21 volume %), such as air, or a non-oxygen atmosphere (oxygen concentration: less than 1 volume %), such as nitrogen. For example, in a case where the substrate to be processed easily undergoes air oxidation, damage to the substrate can be suppressed by performing the heat treatment in an atmosphere with an oxygen concentration of less than 1 volume % to form a cured film.

The irradiation apparatus is not particularly limited as long as plasma irradiation can be performed with the apparatus, and for example, it is possible to use Telius SP or Tactras Vigus manufactured by Tokyo Electron Ltd. It is possible to select an apparatus and set conditions in such a manner as to achieve the advantageous effects of the present invention more prominently.

Through the above-described steps, an insolubilized organic film can be formed on the substrate having the concave-convex pattern. Here, the thickness of the organic film is appropriately selected in accordance with the depth of the pattern, but is preferably 10 to 20,000 nm, particularly preferably 20 to 15,000 nm.

When an organic film formed in this manner is to be applied to a multilayer resist process, it is possible to form a silicon-containing resist middle layer film, a resist upper layer film (monolayer resist film) containing no silicon, or an inorganic hard mask, such as a silicon oxide film, a silicon nitride film, a silicon oxynitride film, an amorphous silicon film, and a titanium nitride film, on the organic film. In addition, the substrate can be highly planarized without using CMP, which is a high-cost process, and therefore, the substrate can be planarized at low cost.

### <Method for Manufacturing Substrate for Semiconductor Device>

The present invention provides a method for manufacturing a substrate for a semiconductor device, the method including:
forming an organic film on a substrate having a concave-convex pattern by the inventive method for forming an organic film described above;
forming a silicon-containing resist middle layer film on the organic film by using a silicon-containing composition for forming a resist middle layer film;
forming a resist upper layer film on the silicon-containing resist middle layer film by using a photoresist composition;
forming a circuit pattern in the resist upper layer film;
transferring the pattern to the silicon-containing resist middle layer film by dry etching while using the resist upper layer film having the formed pattern as a mask;
transferring the pattern to the organic film by dry etching while using the silicon-containing resist middle layer film having the transferred pattern as a mask; and
further transferring the pattern to the substrate by dry etching while using the organic film having the transferred pattern as a mask.

The substrate to be used in the inventive method for manufacturing a substrate for a semiconductor device preferably includes metal film, a metal carbide film, a metal oxide film, a metal nitride film, or a metal oxynitride film.

In addition, the metal constituting the substrate is preferably silicon, titanium, tungsten, hafnium, zirconium, chromium, germanium, copper, aluminum, indium, gallium, arsenic, palladium, iron, tantalum, iridium, molybdenum, or an alloy thereof.

In the method for manufacturing a substrate for a semiconductor device, the organic film can also be applied as a sacrificial film.

It is preferable that the substrate having the concave-convex pattern has an open area (non-patterned area) and a patterned area of DENSE (dense) and ISO (coarse), and the pattern has an aspect ratio of 0.1 to 10. Furthermore, the difference in coating level (Bias) between the open area and the patterned area is preferably 1 to 100 nm.

As the composition for forming an organic film, it is preferable to use a composition containing a resin containing an aromatic ring, as described above. For 193-nm light exposure, when a material containing many aromatic groups and having high resistance to substrate-etching is used, the k-value and thus the substrate reflection are increased in some cases. However, the reflection can be suppressed by the silicon-containing resist middle layer film, and thus, the substrate reflection can be reduced to 0.5% or less. In addition, in exposure to extreme ultraviolet rays (EUV), a fine pattern can be formed when an organic film material containing many aromatic groups and having high substrate-etching resistance is used.

As the silicon-containing resist middle layer film, a polysiloxane-based coating film is preferably used. By imparting an effect as an antireflective film to the silicon-containing resist middle layer film, reflection can be suppressed. Specific examples include silicon-containing resist middle layer films that can be obtained from compositions shown in JP 2004-310019 A, JP 2007-302873 A, JP 2009-126940 A, etc.

The photoresist composition for forming the resist upper layer film may be a positive type or a negative type, and a photoresist composition that is normally used can be used. When the resist upper layer film is to be formed from the photoresist composition, a spin-coating method is preferably used in the same manner as when the organic film is formed. After the spin-coating with the photoresist composition, pre-baking is performed, and the pre-baking is preferably performed at 60 to 180°C for 10 to 300 seconds. Then, light exposure, post-exposure baking (PEB), and development can be performed according to conventional methods to obtain a resist pattern (circuit pattern). Note that the thickness of the resist upper layer film is not particularly limited, but is preferably 30 to 500 nm, particularly preferably 50 to 400 nm.

The circuit pattern is preferably formed by any of a lithography with a high-energy beam having a wavelength of 10 nm or more and 300 nm or less, a direct writing with electron beam, and nanoimprinting, or a combination thereof.

Examples of exposure light include high-energy beams having a wavelength of 300 nm or less, specifically, 248-nm, 193-nm, and 157-nm excimer lasers, soft X-ray of 3 to 20 nm, so-called EUV beam, electron beam, X-ray, etc.

Furthermore, the circuit pattern is preferably developed with an alkaline development or an organic solvent.

Subsequently, etching is performed while using the obtained resist pattern as a mask. The dry etching of the silicon-containing resist middle layer film can be performed, for example, by using a fluorocarbon-based gas while using the resist pattern as a mask. Subsequently, the dry etching of the organic film can be performed by using, for example, oxygen gas or hydrogen gas while using the silicon-containing resist middle layer film pattern (the silicon-containing resist middle layer film having the transferred pattern) as a mask.

The subsequent etching of the substrate can also be performed by a conventional method. For example, a substrate made of SiO₂, SiN, or silica low-dielectric insulating film is etched mainly with a fluorocarbon-based gas; and a substrate made of p-Si, Al, or W is etched mainly with a chlorine- or bromine-based gas. Thus, the pattern can be transferred to the substrate.

On the silicon-containing resist middle layer film, an organic antireflective film (BARC) may be formed, and a resist upper layer film may be formed thereon. That is, the present invention provides a method for manufacturing a substrate for a semiconductor device, the method including:
forming an organic film on a substrate having a concave-convex pattern by the inventive method for forming an organic film described above;
forming a silicon-containing resist middle layer film on the organic film by using a silicon-containing composition for forming a resist middle layer film;
forming an organic antireflective film on the silicon-containing resist middle layer film;
forming a resist upper layer film on the organic antireflective film by using a photoresist composition to obtain a four-layer resist film;
forming a circuit pattern in the resist upper layer film;
transferring the pattern to the organic antireflective film and the silicon-containing resist middle layer film by dry etching while using the resist upper layer film having the formed pattern as a mask;
transferring the pattern to the organic film by dry etching while using the organic antireflective film and the silicon-containing resist middle layer film having the transferred pattern as a mask; and
further transferring the pattern to the substrate by dry etching while using the organic film having the transferred pattern as a mask.

This method can be performed in the same manner as the above-described method for manufacturing a substrate for a semiconductor device, using the silicon-containing resist middle layer film, except that the organic antireflective film is formed on the silicon-containing resist middle layer film. The organic antireflective film is not particularly limited, and a known material can be used, and the organic antireflective film can be formed by a known method such as spin-coating.

It is also possible to form an inorganic hard mask, such as a silicon oxide film, a silicon nitride film, a silicon oxynitride film, an amorphous silicon film, and a titanium nitride film, on the organic film. That is, the present invention provides a method for manufacturing a substrate for a semiconductor device, the method including:
forming an organic film on a substrate having a concave-convex pattern by the inventive method for forming an organic film described above;
forming an inorganic hard mask selected from the group consisting of a silicon oxide film, a silicon nitride film, a silicon oxynitride film, an amorphous silicon film, and a titanium nitride film on the organic film;
forming a resist upper layer film on the inorganic hard mask by using a photoresist composition;
forming a circuit pattern in the resist upper layer film;
transferring the pattern to the inorganic hard mask by dry etching while using the resist upper layer film having the formed pattern as a mask;
transferring the pattern to the organic film by dry etching while using the inorganic hard mask having the transferred pattern as a mask; and
further transferring the pattern to the substrate by dry etching while using the organic film having the transferred pattern as a mask.

The formation of the inorganic hard mask is preferably performed by a CVD method or an ALD method.

The etching of the inorganic hard mask can be performed, for example, by using a fluorocarbon-based gas while using the resist pattern as a mask. Subsequently, the dry etching of the organic film can be performed by using oxygen gas or hydrogen gas while using the inorganic hard mask pattern as a mask. This can be performed in the same manner as the above-described method for manufacturing a substrate for a semiconductor device, using the silicon-containing resist middle layer film, except that the inorganic hard mask is formed instead of the silicon-containing resist middle layer film on the organic film.

It is also possible to form, on the inorganic hard mask, an organic antireflective film or a multilayer resist film including an organic film and a silicon-containing resist middle layer film. That is, the present invention provides a method for manufacturing a substrate for a semiconductor device, the method including:
forming an organic film on a substrate having a concave-convex pattern by the inventive method for forming an organic film described above;
forming an inorganic hard mask selected from the group consisting of a silicon oxide film, a silicon nitride film, a silicon oxynitride film, an amorphous silicon film, and a titanium nitride film on the organic film;
forming an organic antireflective film or a multilayer resist film including an organic film and a silicon-containing resist middle layer film on the inorganic hard mask;
forming a resist upper layer film on the organic antireflective film or the multilayer resist film by using a photoresist composition;
forming a circuit pattern in the resist upper layer film;
transferring the pattern to the inorganic hard mask by dry etching via pattern transfer to the organic antireflective film or the multilayer resist film while using the resist upper layer film having the formed pattern as a mask;
transferring the pattern to the organic film formed on the substrate by dry etching while using the inorganic hard mask having the transferred pattern as a mask; and
further transferring the pattern to the substrate by dry etching while using the organic film having the transferred pattern as a mask.

When an inorganic hard mask, such as a silicon oxide film, a silicon nitride film, a silicon oxynitride film, an amorphous silicon film, or a titanium nitride film, is used, the combination of the inorganic hard mask and the BARC make it possible to suppress the reflection even in liquid immersion exposure at a high NA exceeding 1.0. Another merit of forming the BARC is that it is possible to achieve an effect of widening the process margin immediately above the inorganic hard mask.

This method can be performed in the same manner as the above-described method for manufacturing a substrate for a semiconductor device, using the inorganic hard mask, except that the organic antireflective film or the multilayer resist film including the organic film and the silicon-containing resist middle layer film is formed on the inorganic hard mask.

As described above, an organic film formed by the inventive method has excellent planarizing property. Therefore, by using the organic film in combination with various film materials in multilayer resist processes, for example, two-layer resist processes, three-layer resist processes using a silicon-containing resist middle layer film, or four-layer resist processes using a silicon-containing resist middle layer film and an organic antireflective film, it is possible to transfer an upper layer photoresist (resist upper layer film) pattern to the substrate with high precision and form the pattern in the substrate. That is, according to the inventive method for manufacturing a substrate for a semiconductor device, it is possible to manufacture a substrate for a semiconductor device highly accurately.

### EXAMPLES

Hereinafter, the present invention will be further specifically described with reference to Synthesis Examples, Comparative Synthesis Examples, Examples, and Comparative Examples. However, the present invention is not limited thereto.

### [Preparation of Compositions (UDL-1 to -6) for Forming Organic Film]

Resins (B1) to (B6) for forming an organic film and a solvent (C-1) used for the preparation of compositions for forming an organic film are shown below.

### [Resins for Forming Organic Film]

B1: a resin represented by the following formula (B-1)
B2: a resin represented by the following formula (B-2)
B3: a resin represented by the following formula (B-3)
B4: a resin represented by the following formula (B-4)
B5: a resin represented by the following formula (B-5)
B6: a resin represented by the following formula (B-6)

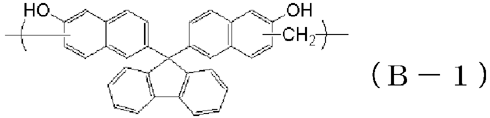

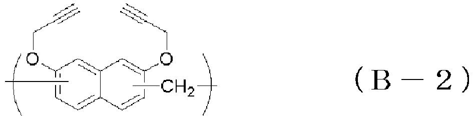

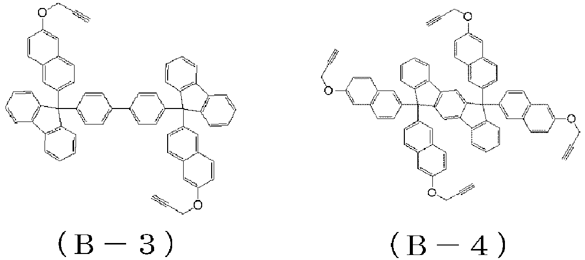

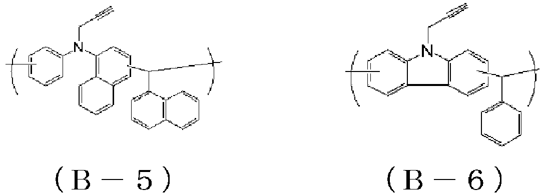

### [Solvent]

### C-1: propylene glycol monomethyl ether acetate (boiling point: 146°C)

Each of the organic film materials (compositions UDL-1 to -6 for forming an organic film) was prepared by dissolving one of the resins (B1) to (B6) for forming an organic film in the proportion shown in Table 1, in a solvent (C-1) containing 0.5% by mass of FC-4430 (manufactured by Sumitomo 3M Limited), and filtering the solution through a 0.1-µm filter made of a fluororesin. Note that the numbers in the table indicates parts by mass.

**[Table 1]**

| Composition for forming organic film | Organic polymer | | Solvent (parts by mass) |
|---|---|---|---|
| | | (parts by mass) | |
| UDL-1 | B-1 | 10 | C-1 (100) |
| UDL-2 | B-2 | 10 | C-1 (100) |
| UDL-3 | B-3 | 10 | C-1 (100) |
| UDL-4 | B-4 | 10 | C-1 (100) |
| UDL-5 | B-5 | 10 | C-1 (100) |
| UDL-6 | B-6 | 10 | C-1 (100) |

(A) Coating solvents (A-1) to (A-5) and an organic solvent (R-1) for a Comparative Example are shown below.

**[Table 2]**

| (A) Coating solvent | Normal boiling point (°C) | Compound structure |
|---|---|---|
| A-1 | 188 | 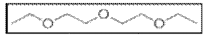 |
| A-2 | 260 | 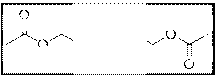 |
| A-3 | 242 | 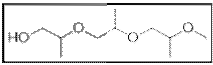 |
| A-4 | 364 | 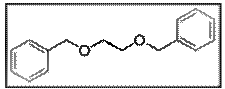 |
| A-5 | 311 | 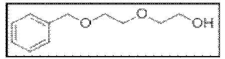 |
| R-1 | 146 | 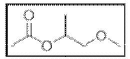 |

### [Evaluation of Solubility in Organic Solvent: Example 1-1 to Example 1-9, Comparative Example 1-1, and Comparative Example 1-2]

Each of the compositions (UDL-1 to -6) for forming an organic film was respectively applied onto a silicon substrate having no concave-convex patterns and baked under the baking conditions shown in Table 3. After that, the film thickness from the central portion to the peripheral portion of the substrate was measured and the average film thickness (a [nm]) was calculated. Subsequently, the coating solvent (A) shown in Table 3 was dispensed thereon, left to stand for 30 seconds, spin-dried, and baked at 100°C for 60 seconds to evaporate the coating solvent. Then, the film thickness (b [nm]) was measured. The difference in film thickness between before and after the coating solvent treatment (film remaining percentage: (b/a) × 100) was calculated.

**[Table 3]**

| Example | Organic film formation | | Film thickness "a" | Step before insolubilization treatment | Film thickness "b" | Film remaining percentage |
|---|---|---|---|---|---|---|
| | Composition for forming organic film | Baking temperature | nm | (A) Coating solvent | nm | (b/a)×100 |
| Example 1-1 | UDL-1 | 250°C | 80.2 | A-1 | 79.7 | 99.4% |
| Example 1-2 | UDL-2 | 220°C | 79.6 | A-2 | 68.7 | 86.3% |
| Example 1-3 | UDL-3 | 250°C | 77.8 | A-3 | 70.3 | 90.4% |
| Example 1-4 | UDL-4 | 250°C | 78.5 | A-4 | 68.9 | 87.8% |
| Example 1-5 | UDL-5 | 250°C | 79.4 | A-5 | 74.2 | 93.5% |
| Example 1-6 | UDL-6 | 250°C | 79.8 | A-5 | 73.4 | 92.0% |
| Example 1-7 | UDL-1 | 250°C | 80.2 | A-5 | 70.5 | 87.9% |
| Example 1-8 | UDL-1 | 270°C | 79.4 | A-5 | 72.4 | 91.2% |
| Example 1-9 | UDL-1 | 300°C | 78.8 | A-5 | 74.3 | 94.3% |
| Comparative Example 1-1 | UDL-1 | 250°C | 80.2 | R-1 | 75.4 | 94.0% |
| Comparative Example 1-2 | UDL-1 | 350°C | 80.2 | A-5 | 80.5 | 100.4% |

As shown in Table 3, in Example 1-1 to Example 1-9, it was observed that, by performing a step of spin-coating a coating film with a coating solvent having a normal boiling point of 160°C or higher and lower than 500°C after forming the coating film and before the insolubilization treatment, the film thickness had decreased after the insolubilization treatment, and part of the coating film had dissolved in the respective coating solvent.

On the other hand, in Comparative Example 1-2, change in the film thickness between before and after the application of the coating solvent was hardly observed. This indicates that the resin (the organic polymer (B-1) in UDL-1) in the coating film was insoluble in the coating solvent (A-5). The reason why the film thickness after the application of the coating solvent was slightly thicker than the film thickness before the application of the coating solvent in this Comparative Example is conjectured to be that the baking was not performed at a sufficiently higher temperature than the boiling point of the coating solvent, and therefore, the coating solvent remained in the coating film, and the film thickness increased.

### [Planarizing Property Evaluation: Examples 2-1 to 2-10 and Comparative Examples 2-1 to 2-8]

### [Pattern A]

Each of the compositions (UDL-1 to -6) for forming an organic film was respectively applied onto an underlying substrate 5 (SiO₂ wafer substrate) having a giant isolated trench pattern (FIG. 3 (A), trench width: 10 µm, trench depth: 0.10 µm), and baked under the conditions described in Table 4. Then, each coating solvent was respectively applied onto the organic film by spin-coating and the resultant was treated by the insolubilization treatment method described in Table 4. After that, the step (delta 7 in FIG. 3 (B)) between the trench portion and the non-trench portion of the insolubilized coating film (organic film) 6 was observed using an atomic force microscope (AFM) NX10 manufactured by Park Systems. The results are shown in Table 4. In this evaluation (flatness A), it can be said that the smaller the step, the better the planarizing property. Note that, in this evaluation, a trench pattern having a depth of 0.10 µm was planarized by forming an organic film generally having a film thickness of approximately 0.2 µm by using a composition for forming an organic film, and this is a special, severe evaluation condition to evaluate the planarizing property.

### [Pattern B]

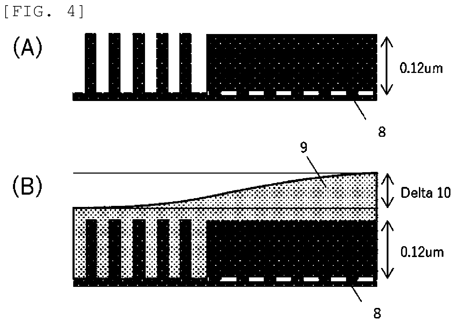

Each of the compositions (UDL-1 to -6) for forming an organic film was respectively applied onto an underlying substrate 8 (SiO₂ wafer substrate) having a dense line-and-space pattern (FIG. 4 (A), line width: 60 nm, line depth: 100 nm, distance between the centers of two adjacent lines: 120 nm), and baked under the conditions described in Table 4**.** Then, each coating solvent was respectively applied onto the organic film by spin-coating and the resultant was treated by the insolubilization treatment method described in Table 4**.** After that, the cross-sectional shape of each of the obtained wafer substrates was observed using a scanning electron microscope (SEM), and the step Delta 10 between the line-pattern-dense portion and the non-line-patterned portion of the insolubilization coating film (filling film) 9 was observed using an electron microscope (S-4700) manufactured by Hitachi, Ltd. The results are shown in Table 4**.** In this evaluation (flatness B), it can be said that the smaller the step, the better the planarizing property.

### Additional Treatment Conditions (Plasma Treatment)

Plasma treatment was performed under the following conditions by using an etching apparatus Telius manufactured by Tokyo Electron Ltd.

### Plasma treatment conditions

Chamber pressure: 100 mT
RF-power (upper portion): 100 W
RF-power (lower portion): 3500 W
H₂ gas flow rate: 200 sccm
Time: 20 sec

**[Table 4]**

| Example | Organic film formation | | Step before insolubilization treatment | Insolubilization treatment | Flatness A | Flatness B |
|---|---|---|---|---|---|---|
| | Composition for forming organic film | Baking temperature | (A) Coating solvent | Method (1) | nm | nm |
| Example 2-1 | UDL-1 | 250°C | A-1 | 350°C | 95 | 35 |
| Example 2-2 | UDL-2 | 220°C | A-2 | 350°C | 100 | 35 |
| Example 2-3 | UDL-3 | 250°C | A-3 | 350°C | 70 | 30 |
| Example 2-4 | UDL-4 | 250°C | A-4 | 350°C | 75 | 32 |
| Example 2-5 | UDL-5 | 250°C | A-5 | 350°C | 85 | 34 |
| Example 2-6 | UDL-6 | 250°C | A-5 | 350°C | 85 | 35 |
| Example 2-7 | UDL-1 | 250°C | A-5 | 350°C | 80 | 31 |
| Example 2-8 | UDL-1 | 270°C | A-5 | 350°C | 75 | 29 |
| Example 2-9 | UDL-1 | 300°C | A-5 | 350°C | 80 | 30 |
| Example 2-10 | UDL-1 | 270°C | A-5 | Plasma treatment | 80 | 31 |
| Comparative Example 2-1 | UDL-1 | 350°C | None | - | 110 | 40 |
| Comparative Example 2-2 | UDL-1 | 250°C | R-1 | 350°C | 105 | 39 |
| Comparative Example 2-3 | UDL-1 | 350°C | A-5 | 350°C | 110 | 40 |
| Comparative Example 2-4 | UDL-2 | 350°C | None | - | 120 | 39 |
| Comparative Example 2-5 | UDL-3 | 350°C | None | - | 90 | 34 |
| Comparative Example 2-6 | UDL-4 | 350°C | None | - | 95 | 36 |
| Comparative Example 2-7 | UDL-5 | 350°C | None | - | 105 | 38 |
| Comparative Example 2-8 | UDL-6 | 350°C | None | - | 105 | 39 |

As shown in Table 4, it was confirmed that better planarizing property was exhibited in both pattern A and pattern B in Examples 2-1 to 2-10, using the inventive method for forming an organic film, than in Comparative Examples 2-1 and 2-4 to 2-8, using a conventional method (not including a step of spin-coating the coating film with a coating solvent having a normal boiling point of 160°C or higher and lower than 500°C before the insolubilization treatment) for forming an organic film.

In particular, excellent planarizing property was exhibited in Examples 2-4, 2-5, and 2-7 to 2-9, using, as the coating solvent, aromatic group-containing compounds (A-4) and (A-5) having a benzyl group or a benzoyl group.

On the other hand, in the method for forming an organic film including a step of spin-coating the coating film with an organic solvent having a boiling point lower than 160°C (Comparative Example 2-2), improvement in flatness from conventional methods for forming an organic film was insufficient. Meanwhile, in the method for forming an organic film (Comparative Example 2-3), in which no change in film thickness was observed between before and after the coating solvent treatment in the solvent resistance evaluation of Example 1, it was not possible for the coating solvent to dissolve the coating film, and it was not possible to impart sufficient thermal flowability to the resin component in the uncured coating film. Therefore, no improvement in flatness from conventional methods for forming an organic film was observed.

It is considered that, in the inventive method for forming an organic film, the coating film before the insolubilization treatment dissolves in the coating solvent and the resin component in the uncured coating film can achieve sufficient thermal flowability, and therefore, a resist underlayer film excellent in filling and planarizing properties can be formed. Accordingly, it is favorable that the coating film before the insolubilization treatment dissolves in the coating solvent, and from the results of Examples 1 and Examples 2, it can be said that the ratio b/a is preferably 99.5% or less, where "a" is the film thickness of the coating film before the insolubilization treatment, formed by spin-coating using a composition for forming an organic film, and "b" is the film thickness of the organic film formed by spin-coating the coating film with the coating solvent and then performing a heat treatment at 100°C for 60 seconds.

The present description includes the following embodiments.
[1]: A method for forming an organic film on a substrate having a concave-convex pattern, the method comprising the steps of:
   forming a coating film on the substrate by spin-coating with a composition for forming an organic film;
   spin-coating the coating film with a coating solvent that is capable of dissolving the coating film and has a normal boiling point of 160°C or higher and lower than 500°C; and
   forming an organic film by subjecting the coating film to an insolubilization treatment against the coating solvent.
[2]: The method for forming an organic film of [1], wherein any of a heat treatment at 100°C or higher and 600°C or lower, an irradiation treatment with an ultraviolet ray having a wavelength of 400 nm or less, an irradiation treatment with an electron beam, and an irradiation treatment with plasma, or a combination thereof is used as the insolubilization treatment.
[3]: The method for forming an organic film of [1] or [2], wherein an alcohol, an ester, a ketone, a carbonate, an ether, or a combination thereof is used as the coating solvent.
[4]: The method for forming an organic film of any one of [1] to [3], wherein an aromatic group-containing compound having a benzyl group or a benzoyl group is used as the coating solvent.
[5]: The method for forming an organic film of any one of [1] to [4], wherein a composition containing a resin containing one or more aromatic rings is used as the composition for forming an organic film.
[6]: A method for manufacturing a substrate for a semiconductor device, the method comprising:
   forming an organic film on a substrate having a concave-convex pattern by the method of any one of [1] to [5];
   forming a silicon-containing resist middle layer film on the organic film by using a silicon-containing composition for forming a resist middle layer film;
   forming a resist upper layer film on the silicon-containing resist middle layer film by using a photoresist composition;
   forming a circuit pattern in the resist upper layer film;
   transferring the pattern to the silicon-containing resist middle layer film by dry etching while using the resist upper layer film having the formed pattern as a mask;
   transferring the pattern to the organic film by dry etching while using the silicon-containing resist middle layer film having the transferred pattern as a mask; and
   further transferring the pattern to the substrate by dry etching while using the organic film having the transferred pattern as a mask.
[7]: A method for manufacturing a substrate for a semiconductor device, the method comprising:
   forming an organic film on a substrate having a concave-convex pattern by the method of any one of [1] to [5];
   forming a silicon-containing resist middle layer film on the organic film by using a silicon-containing composition for forming a resist middle layer film;
   forming an organic antireflective film on the silicon-containing resist middle layer film;
   forming a resist upper layer film on the organic antireflective film by using a photoresist composition to obtain a four-layer resist film;
   forming a circuit pattern in the resist upper layer film;
   transferring the pattern to the organic antireflective film and the silicon-containing resist middle layer film by dry etching while using the resist upper layer film having the formed pattern as a mask;
   transferring the pattern to the organic film by dry etching while using the organic antireflective film and the silicon-containing resist middle layer film having the transferred pattern as a mask; and
   further transferring the pattern to the substrate by dry etching while using the organic film having the transferred pattern as a mask.
[8]: A method for manufacturing a substrate for a semiconductor device, the method comprising:
   forming an organic film on a substrate having a concave-convex pattern by the method of any one of [1] to [5];
   forming an inorganic hard mask selected from the group consisting of a silicon oxide film, a silicon nitride film, a silicon oxynitride film, an amorphous silicon film, and a titanium nitride film on the organic film;
   forming a resist upper layer film on the inorganic hard mask by using a photoresist composition;
   forming a circuit pattern in the resist upper layer film;
   transferring the pattern to the inorganic hard mask by dry etching while using the resist upper layer film having the formed pattern as a mask;
   transferring the pattern to the organic film by dry etching while using the inorganic hard mask having the transferred pattern as a mask; and
   further transferring the pattern to the substrate by dry etching while using the organic film having the transferred pattern as a mask.
[9]: A method for manufacturing a substrate for a semiconductor device, the method comprising:
   forming an organic film on a substrate having a concave-convex pattern by the method of any one of [1] to [5];
   forming an inorganic hard mask selected from the group consisting of a silicon oxide film, a silicon nitride film, a silicon oxynitride film, an amorphous silicon film, and a titanium nitride film on the organic film;
   forming an organic antireflective film or a multilayer resist film comprising an organic film and a silicon-containing resist middle layer film on the inorganic hard mask;
   forming a resist upper layer film on the organic antireflective film or the multilayer resist film by using a photoresist composition;
   forming a circuit pattern in the resist upper layer film;
   transferring the pattern to the inorganic hard mask by dry etching via pattern transfer to the organic antireflective film or the multilayer resist film while using the resist upper layer film having the formed pattern as a mask;
   transferring the pattern to the organic film formed on the substrate by dry etching while using the inorganic hard mask having the transferred pattern as a mask; and
   further transferring the pattern to the substrate by dry etching while using the organic film having the transferred pattern as a mask.
[10]: The method for manufacturing a substrate for a semiconductor device of [8] or [9], wherein the inorganic hard mask is formed by a CVD method or an ALD method.
[11]: The method for manufacturing a substrate for a semiconductor device of any one of [6] to [10], wherein the circuit pattern is formed by any of a lithography with a high-energy beam having a wavelength of 10 nm or more and 300 nm or less, a direct writing with electron beam, and nanoimprinting, or a combination thereof.
[12]: The method for manufacturing a substrate for a semiconductor device of any one of [6] to [11], wherein the circuit pattern is developed by alkaline development or development with an organic solvent.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for forming an organic film on a substrate having a concave-convex pattern, the method comprising the steps of:
forming a coating film on the substrate by spin-coating with a composition for forming an organic film;
spin-coating the coating film with a coating solvent that is capable of dissolving the coating film and has a normal boiling point of 160°C or higher and lower than 500°C; and
forming an organic film by subjecting the coating film to an insolubilization treatment against the coating solvent.

2. The method for forming an organic film according to claim 1, wherein any of a heat treatment at 100°C or higher and 600°C or lower, an irradiation treatment with an ultraviolet ray having a wavelength of 400 nm or less, an irradiation treatment with an electron beam, and an irradiation treatment with plasma, or a combination thereof is used as the insolubilization treatment.

3. The method for forming an organic film according to claim 1 or 2, wherein an alcohol, an ester, a ketone, a carbonate, an ether, or a combination thereof is used as the coating solvent.

4. The method for forming an organic film according to any one of claims 1 to 3, wherein an aromatic group-containing compound having a benzyl group or a benzoyl group is used as the coating solvent.

5. The method for forming an organic film according to any one of claims 1 to 4, wherein a composition containing a resin containing one or more aromatic rings is used as the composition for forming an organic film.

6. A method for manufacturing a substrate for a semiconductor device, the method comprising:
forming an organic film on a substrate having a concave-convex pattern by the method according to any one of claims 1 to 5;
forming a silicon-containing resist middle layer film on the organic film by using a silicon-containing composition for forming a resist middle layer film;
forming a resist upper layer film on the silicon-containing resist middle layer film by using a photoresist composition;
forming a circuit pattern in the resist upper layer film;
transferring the pattern to the silicon-containing resist middle layer film by dry etching while using the resist upper layer film having the formed pattern as a mask;
transferring the pattern to the organic film by dry etching while using the silicon-containing resist middle layer film having the transferred pattern as a mask; and
further transferring the pattern to the substrate by dry etching while using the organic film having the transferred pattern as a mask.

7. A method for manufacturing a substrate for a semiconductor device, the method comprising:
forming an organic film on a substrate having a concave-convex pattern by the method according to any one of claims 1 to 5;
forming a silicon-containing resist middle layer film on the organic film by using a silicon-containing composition for forming a resist middle layer film;
forming an organic antireflective film on the silicon-containing resist middle layer film;
forming a resist upper layer film on the organic antireflective film by using a photoresist composition to obtain a four-layer resist film;
forming a circuit pattern in the resist upper layer film;
transferring the pattern to the organic antireflective film and the silicon-containing resist middle layer film by dry etching while using the resist upper layer film having the formed pattern as a mask;
transferring the pattern to the organic film by dry etching while using the organic antireflective film and the silicon-containing resist middle layer film having the transferred pattern as a mask; and
further transferring the pattern to the substrate by dry etching while using the organic film having the transferred pattern as a mask.

8. A method for manufacturing a substrate for a semiconductor device, the method comprising:
forming an organic film on a substrate having a concave-convex pattern by the method according to any one of claims 1 to 5;
forming an inorganic hard mask selected from the group consisting of a silicon oxide film, a silicon nitride film, a silicon oxynitride film, an amorphous silicon film, and a titanium nitride film on the organic film;
forming a resist upper layer film on the inorganic hard mask by using a photoresist composition;
forming a circuit pattern in the resist upper layer film;
transferring the pattern to the inorganic hard mask by dry etching while using the resist upper layer film having the formed pattern as a mask;
transferring the pattern to the organic film by dry etching while using the inorganic hard mask having the transferred pattern as a mask; and
further transferring the pattern to the substrate by dry etching while using the organic film having the transferred pattern as a mask.

9. A method for manufacturing a substrate for a semiconductor device, the method comprising:
forming an organic film on a substrate having a concave-convex pattern by the method according to any one of claims 1 to 5;
forming an inorganic hard mask selected from the group consisting of a silicon oxide film, a silicon nitride film, a silicon oxynitride film, an amorphous silicon film, and a titanium nitride film on the organic film;
forming an organic antireflective film or a multilayer resist film comprising an organic film and a silicon-containing resist middle layer film on the inorganic hard mask;
forming a resist upper layer film on the organic antireflective film or the multilayer resist film by using a photoresist composition;
forming a circuit pattern in the resist upper layer film;
transferring the pattern to the inorganic hard mask by dry etching via pattern transfer to the organic antireflective film or the multilayer resist film while using the resist upper layer film having the formed pattern as a mask;
transferring the pattern to the organic film formed on the substrate by dry etching while using the inorganic hard mask having the transferred pattern as a mask; and
further transferring the pattern to the substrate by dry etching while using the organic film having the transferred pattern as a mask.

10. The method for manufacturing a substrate for a semiconductor device according to claim 8 or 9, wherein the inorganic hard mask is formed by a CVD method or an ALD method.

11. The method for manufacturing a substrate for a semiconductor device according to any one of claims 6 to 10, wherein the circuit pattern is formed by any of a lithography with a high-energy beam having a wavelength of 10 nm or more and 300 nm or less, a direct writing with electron beam, and nanoimprinting, or a combination thereof.

12. The method for manufacturing a substrate for a semiconductor device according to any one of claims 6 to 11, wherein the circuit pattern is developed by alkaline development or development with an organic solvent.
